# EUROPEAN PATENT APPLICATION

(11) **EP 4 760 454 A1**
(43) Date of publication of application: **17.06.2026**
(21) Application number: 24865679.5
(22) Date of filing: 29.07.2024
(51) Int. Cl.: G06F 1/20, G06F 1/16

(54) **ELECTRONIC DEVICE INCLUDING STRUCTURE FOR DISSIPATING HEAT**

(30) Priority: 15.09.2023 KR 20230123524; 30.10.2023 KR 20230147235
(71) Applicant: Samsung Electronics Co., Ltd., Suwon-si, Gyeonggi-do 16677 (KR)
(72) Inventor: CHUNG, Haein, Suwon-si Gyeonggi-do 16677 (KR); KIM, Jihong, Suwon-si Gyeonggi-do 16677 (KR)
(74) Representative: Gulde & Partner
(86) International application number: PCT/KR2024/011052
(87) International publication number: WO 2025/058236

(57) **Abstract**

An electronic device according to an embodiment may comprise: a first housing including a first supporting portion; a second housing including a second supporting portion opposite to the first supporting portion; and at least one electronic component in the first housing. The electronic device may include a hinge structure which rotatably couples the first housing and the second housing to each other. The first supporting portion and the second supporting portion may be configured to be connected to each other in an unfolded state of the electronic device, thereby forming a heat transfer path from the at least one electronic component to the second housing.

## Description

### [Technical Field]

Various embodiments to be described later relate to an electronic device including a structure for dissipating heat.

### [Background Art]

An electronic device including a large-screen display may increase user utilization. As a demand for an electronic device having high portability increases, the electronic device may include a deformable display. The deformable display may be deformable in a slidable manner, deformable in a rollable manner, or deformable in a foldable manner. The electronic device may be miniaturized to be worn by a user or carried by the user by including the deformable display. The electronic device may include electronic components in the electronic device to implement various functions of the electronic device. As the electronic components disposed in the electronic device perform an operation for responding to a request of the user, heat may be generated in the miniaturized electronic device. In order to reduce damage to the electronic device, the electronic device may require a structure for dissipating heat generated from the electronic components.

The above-described information may be provided as a related art for the purpose of helping understanding of the present disclosure. No argument or decision is made as to whether any of the above description may be applied as a prior art related to the present disclosure.

### [Disclosure]

### [Technical Solution]

According to an embodiment, an electronic device may comprise a display, a first housing including a first supporting portion for supporting the display, and a second housing including a second supporting portion for supporting the display. The electronic device may comprise at least one electronic component disposed in the first housing. The electronic device may comprise a hinge structure configured to rotatably couple the first housing and second housing. The first supporting portion and the second supporting portion may be configured to form a heat transfer path from the at least one electronic component to the second housing by being connected to each other in an unfolded state of the electronic device.

According to an embodiment, an electronic device may comprise a first housing including a first supporting portion, and a second housing including a second supporting portion facing the first supporting portion. The electronic device may comprise a flexible display including a first display region coupled on the first housing, a second display region coupled on the second housing, and a third display region, which is deformable, extending from the first display region to the second display region. The electronic device may comprise at least one electronic component in the first housing. The electronic device may comprise a vapor chamber in the first housing contacting the at least one electronic component and the first supporting portion, and extending from the at least one electronic component to the first supporting portion. The electronic device may comprise a hinge structure configured to provide a plurality of folded states in which the second housing is folded relative to a folding axis with respect to the first housing and an unfolded state by rotatably coupling the first supporting portion and the second supporting portion. The first supporting portion may be configured to form a heat transfer path from the at least one electronic component through the vapor chamber to the second housing by being connected with the second supporting portion in the unfolded state.

### [Description of the Drawings]

FIG. 1 is a block diagram of an electronic device in a network environment according to various embodiments.
FIG. 2A illustrates an example of an unfolded state of an exemplary electronic device according to an embodiment.
FIG. 2B illustrates an example of a first folded state of an exemplary electronic device according to an embodiment.
FIG. 2C is an exploded view of an exemplary electronic device according to an embodiment.
FIG. 3 is a partial cross-sectional view of an exemplary electronic device cut along line A-A' of FIG. 2A.
FIGS. 4A and 4B illustrate a portion of an exemplary electronic device.
FIG. 5A illustrates a portion of an exemplary electronic device in a first folded state.
FIG. 5B illustrates a portion of an exemplary electronic device in a second folded state.
FIG. 5C illustrates a portion of an exemplary electronic device in an unfolded state.
FIG. 6 illustrates a portion of an exemplary electronic device in an unfolded state.
FIG. 7A illustrates a portion of an exemplary electronic device in a first folded state.
FIG. 7B illustrates a portion of an exemplary electronic device in an unfolded state.
FIG. 7C is a top plan view of a supporting structure of an exemplary electronic device.
FIG. 8A illustrates a portion of an exemplary electronic device in a first folded state.
FIG. 8B illustrates a portion of an exemplary electronic device in an unfolded state.
FIG. 8C is a partially exploded perspective view of an exemplary electronic device.

### [Mode for Invention]

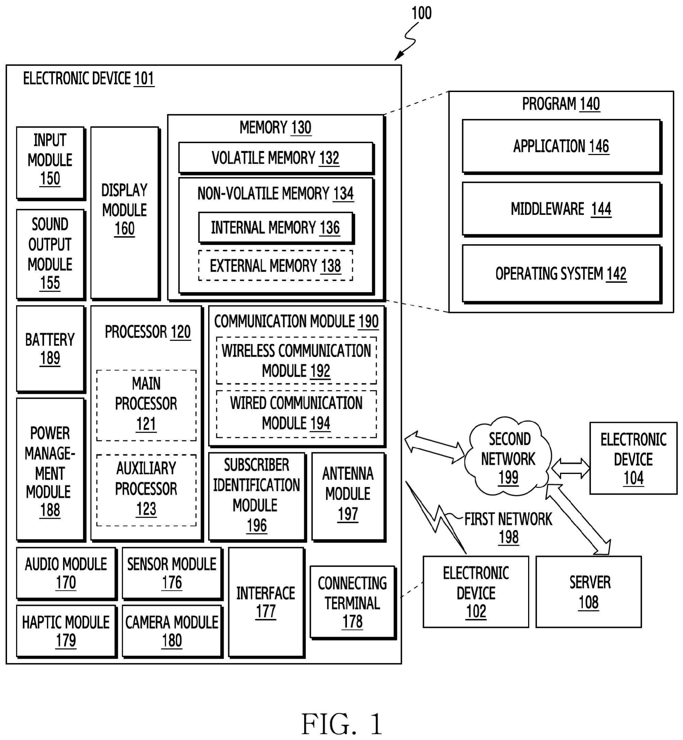

FIG. 1 is a block diagram illustrating an electronic device 101 in a network environment 100 according to various embodiments.

Referring to FIG. 1, the electronic device 101 in the network environment 100 may communicate with an electronic device 102 via a first network 198 (e.g., a short-range wireless communication network), or at least one of an electronic device 104 or a server 108 via a second network 199 (e.g., a long-range wireless communication network). According to an embodiment, the electronic device 101 may communicate with the electronic device 104 via the server 108. According to an embodiment, the electronic device 101 may include a processor 120, memory 130, an input module 150, a sound output module 155, a display module 160, an audio module 170, a sensor module 176, an interface 177, a connecting terminal 178, a haptic module 179, a camera module 180, a power management module 188, a battery 189, a communication module 190, a subscriber identification module(SIM) 196, or an antenna module 197. In some embodiments, at least one of the components (e.g., the connecting terminal 178) may be omitted from the electronic device 101, or one or more other components may be added in the electronic device 101. In some embodiments, some of the components (e.g., the sensor module 176, the camera module 180, or the antenna module 197) may be implemented as a single component (e.g., the display module 160).

The processor 120 may execute, for example, software (e.g., a program 140) to control at least one other component (e.g., a hardware or software component) of the electronic device 101 coupled with the processor 120, and may perform various data processing or computation. According to an embodiment, as at least part of the data processing or computation, the processor 120 may store a command or data received from another component (e.g., the sensor module 176 or the communication module 190) in volatile memory 132, process the command or the data stored in the volatile memory 132, and store resulting data in non-volatile memory 134. According to an embodiment, the processor 120 may include a main processor 121 (e.g., a central processing unit (CPU) or an application processor (AP)), or an auxiliary processor 123 (e.g., a graphics processing unit (GPU), a neural processing unit (NPU), an image signal processor (ISP), a sensor hub processor, or a communication processor (CP)) that is operable independently from, or in conjunction with, the main processor 121. For example, when the electronic device 101 includes the main processor 121 and the auxiliary processor 123, the auxiliary processor 123 may be adapted to consume less power than the main processor 121, or to be specific to a specified function. The auxiliary processor 123 may be implemented as separate from, or as part of the main processor 121.

The auxiliary processor 123 may control at least some of functions or states related to at least one component (e.g., the display module 160, the sensor module 176, or the communication module 190) among the components of the electronic device 101, instead of the main processor 121 while the main processor 121 is in an inactive (e.g., sleep) state, or together with the main processor 121 while the main processor 121 is in an active state (e.g., executing an application). According to an embodiment, the auxiliary processor 123 (e.g., an image signal processor or a communication processor) may be implemented as part of another component (e.g., the camera module 180 or the communication module 190) functionally related to the auxiliary processor 123. According to an embodiment, the auxiliary processor 123 (e.g., the neural processing unit) may include a hardware structure specified for artificial intelligence model processing. An artificial intelligence model may be generated by machine learning. Such learning may be performed, e.g., by the electronic device 101 where the artificial intelligence is performed or via a separate server (e.g., the server 108). Learning algorithms may include, but are not limited to, e.g., supervised learning, unsupervised learning, semi-supervised learning, or reinforcement learning. The artificial intelligence model may include a plurality of artificial neural network layers. The artificial neural network may be a deep neural network (DNN), a convolutional neural network (CNN), a recurrent neural network (RNN), a restricted Boltzmann machine (RBM), a deep belief network (DBN), a bidirectional recurrent deep neural network (BRDNN), deep Q-network or a combination of two or more thereof but is not limited thereto. The artificial intelligence model may, additionally or alternatively, include a software structure other than the hardware structure.

The memory 130 may store various data used by at least one component (e.g., the processor 120 or the sensor module 176) of the electronic device 101. The various data may include, for example, software (e.g., the program 140) and input data or output data for a command related thereto. The memory 130 may include the volatile memory 132 or the non-volatile memory 134.

The program 140 may be stored in the memory 130 as software, and may include, for example, an operating system (OS) 142, middleware 144, or an application 146.

The input module 150 may receive a command or data to be used by another component (e.g., the processor 120) of the electronic device 101, from the outside (e.g., a user) of the electronic device 101. The input module 150 may include, for example, a microphone, a mouse, a keyboard, a key (e.g., a button), or a digital pen (e.g., a stylus pen).

The sound output module 155 may output sound signals to the outside of the electronic device 101. The sound output module 155 may include, for example, a speaker or a receiver. The speaker may be used for general purposes, such as playing multimedia or playing record. The receiver may be used for receiving incoming calls. According to an embodiment, the receiver may be implemented as separate from, or as part of the speaker.

The display module 160 may visually provide information to the outside (e.g., a user) of the electronic device 101. The display module 160 may include, for example, a display, a hologram device, or a projector and control circuitry to control a corresponding one of the display, hologram device, and projector. According to an embodiment, the display module 160 may include a touch sensor adapted to detect a touch, or a pressure sensor adapted to measure the intensity of force incurred by the touch.

The audio module 170 may convert a sound into an electrical signal and vice versa. According to an embodiment, the audio module 170 may obtain the sound via the input module 150, or output the sound via the sound output module 155 or a headphone of an external electronic device (e.g., an electronic device 102) directly (e.g., wiredly) or wirelessly coupled with the electronic device 101.

The sensor module 176 may detect an operational state (e.g., power or temperature) of the electronic device 101 or an environmental state (e.g., a state of a user) external to the electronic device 101, and then generate an electrical signal or data value corresponding to the detected state. According to an embodiment, the sensor module 176 may include, for example, a gesture sensor, a gyro sensor, an atmospheric pressure sensor, a magnetic sensor, an acceleration sensor, a grip sensor, a proximity sensor, a color sensor, an infrared (IR) sensor, a biometric sensor, a temperature sensor, a humidity sensor, or an illuminance sensor.

The interface 177 may support one or more specified protocols to be used for the electronic device 101 to be coupled with the external electronic device (e.g., the electronic device 102) directly (e.g., wiredly) or wirelessly. According to an embodiment, the interface 177 may include, for example, a high definition multimedia interface (HDMI), a universal serial bus (USB) interface, a secure digital (SD) card interface, or an audio interface.

A connecting terminal 178 may include a connector via which the electronic device 101 may be physically connected with the external electronic device (e.g., the electronic device 102). According to an embodiment, the connecting terminal 178 may include, for example, an HDMI connector, a USB connector, an SD card connector, or an audio connector (e.g., a headphone connector).

The haptic module 179 may convert an electrical signal into a mechanical stimulus (e.g., a vibration or a movement) or electrical stimulus which may be recognized by a user via his tactile sensation or kinesthetic sensation. According to an embodiment, the haptic module 179 may include, for example, a motor, a piezoelectric element, or an electric stimulator.

The camera module 180 may capture a still image or moving images. According to an embodiment, the camera module 180 may include one or more lenses, image sensors, image signal processors, or flashes.

The power management module 188 may manage power supplied to the electronic device 101. According to an embodiment, the power management module 188 may be implemented as at least part of, for example, a power management integrated circuit (PMIC).

The battery 189 may supply power to at least one component of the electronic device 101. According to an embodiment, the battery 189 may include, for example, a primary cell which is not rechargeable, a secondary cell which is rechargeable, or a fuel cell.

The communication module 190 may support establishing a direct (e.g., wired) communication channel or a wireless communication channel between the electronic device 101 and the external electronic device (e.g., the electronic device 102, the electronic device 104, or the server 108) and performing communication via the established communication channel. The communication module 190 may include one or more communication processors that are operable independently from the processor 120 (e.g., the application processor (AP)) and supports a direct (e.g., wired) communication or a wireless communication. According to an embodiment, the communication module 190 may include a wireless communication module 192 (e.g., a cellular communication module, a short-range wireless communication module, or a global navigation satellite system (GNSS) communication module) or a wired communication module 194 (e.g., a local area network (LAN) communication module or a power line communication (PLC) module). A corresponding one of these communication modules may communicate with the external electronic device via the first network 198 (e.g., a short-range communication network, such as Bluetooth^{™}, wireless-fidelity (Wi-Fi) direct, or infrared data association (IrDA)) or the second network 199 (e.g., a long-range communication network, such as a legacy cellular network, a 5G network, a next-generation communication network, the Internet, or a computer network (e.g., LAN or wide area network (WAN)). These various types of communication modules may be implemented as a single component (e.g., a single chip), or may be implemented as multi components (e.g., multi chips) separate from each other. The wireless communication module 192 may identify and authenticate the electronic device 101 in a communication network, such as the first network 198 or the second network 199, using subscriber information (e.g., international mobile subscriber identity (IMSI)) stored in the subscriber identification module 196.

The wireless communication module 192 may support a 5G network, after a 4G network, and next-generation communication technology, e.g., new radio (NR) access technology. The NR access technology may support enhanced mobile broadband (eMBB), massive machine type communications (mMTC), or ultra-reliable and low-latency communications (URLLC). The wireless communication module 192 may support a high-frequency band (e.g., the mmWave band) to achieve, e.g., a high data transmission rate. The wireless communication module 192 may support various technologies for securing performance on a high-frequency band, such as, e.g., beamforming, massive multiple-input and multiple-output (massive MIMO), full dimensional MIMO (FD-MIMO), array antenna, analog beam-forming, or large scale antenna. The wireless communication module 192 may support various requirements specified in the electronic device 101, an external electronic device (e.g., the electronic device 104), or a network system (e.g., the second network 199). According to an embodiment, the wireless communication module 192 may support a peak data rate (e.g., 20Gbps or more) for implementing eMBB, loss coverage (e.g., 164dB or less) for implementing mMTC, or U-plane latency (e.g., 0.5ms or less for each of downlink (DL) and uplink (UL), or a round trip of 1ms or less) for implementing URLLC.

The antenna module 197 may transmit or receive a signal or power to or from the outside (e.g., the external electronic device) of the electronic device 101. According to an embodiment, the antenna module 197 may include an antenna including a radiating element composed of a conductive material or a conductive pattern formed in or on a substrate (e.g., a printed circuit board (PCB)). According to an embodiment, the antenna module 197 may include a plurality of antennas (e.g., array antennas). In such a case, at least one antenna appropriate for a communication scheme used in the communication network, such as the first network 198 or the second network 199, may be selected, for example, by the communication module 190 (e.g., the wireless communication module 192) from the plurality of antennas. The signal or the power may then be transmitted or received between the communication module 190 and the external electronic device via the selected at least one antenna. According to an embodiment, another component (e.g., a radio frequency integrated circuit (RFIC)) other than the radiating element may be additionally formed as part of the antenna module 197.

According to various embodiments, the antenna module 197 may form a mmWave antenna module. According to an embodiment, the mmWave antenna module may include a printed circuit board, an RFIC disposed on a first surface (e.g., the bottom surface) of the printed circuit board, or adjacent to the first surface and capable of supporting a designated high-frequency band (e.g., the mmWave band), and a plurality of antennas (e.g., array antennas) disposed on a second surface (e.g., the top or a side surface) of the printed circuit board, or adjacent to the second surface and capable of transmitting or receiving signals of the designated high-frequency band.

At least some of the above-described components may be coupled mutually and communicate signals (e.g., commands or data) therebetween via an inter-peripheral communication scheme (e.g., a bus, general purpose input and output (GPIO), serial peripheral interface (SPI), or mobile industry processor interface (MIPI)).

According to an embodiment, commands or data may be transmitted or received between the electronic device 101 and the external electronic device 104 via the server 108 coupled with the second network 199. Each of the electronic devices 102 or 104 may be a device of a same type as, or a different type, from the electronic device 101. According to an embodiment, all or some of operations to be executed at the electronic device 101 may be executed at one or more of the external electronic devices 102, 104, or 108. For example, if the electronic device 101 should perform a function or a service automatically, or in response to a request from a user or another device, the electronic device 101, instead of, or in addition to, executing the function or the service, may request the one or more external electronic devices to perform at least part of the function or the service. The one or more external electronic devices receiving the request may perform the at least part of the function or the service requested, or an additional function or an additional service related to the request, and transfer an outcome of the performing to the electronic device 101. The electronic device 101 may provide the outcome, with or without further processing of the outcome, as at least part of a reply to the request. To that end, a cloud computing, distributed computing, mobile edge computing (MEC), or client-server computing technology may be used, for example. The electronic device 101 may provide ultra low-latency services using, e.g., distributed computing or mobile edge computing. In another embodiment, the external electronic device 104 may include an internet-of-things (IoT) device. The server 108 may be an intelligent server using machine learning and/or a neural network. According to an embodiment, the external electronic device 104 or the server 108 may be included in the second network 199. The electronic device 101 may be applied to intelligent services (e.g., smart home, smart city, smart car, or healthcare) based on 5G communication technology or IoT-related technology.

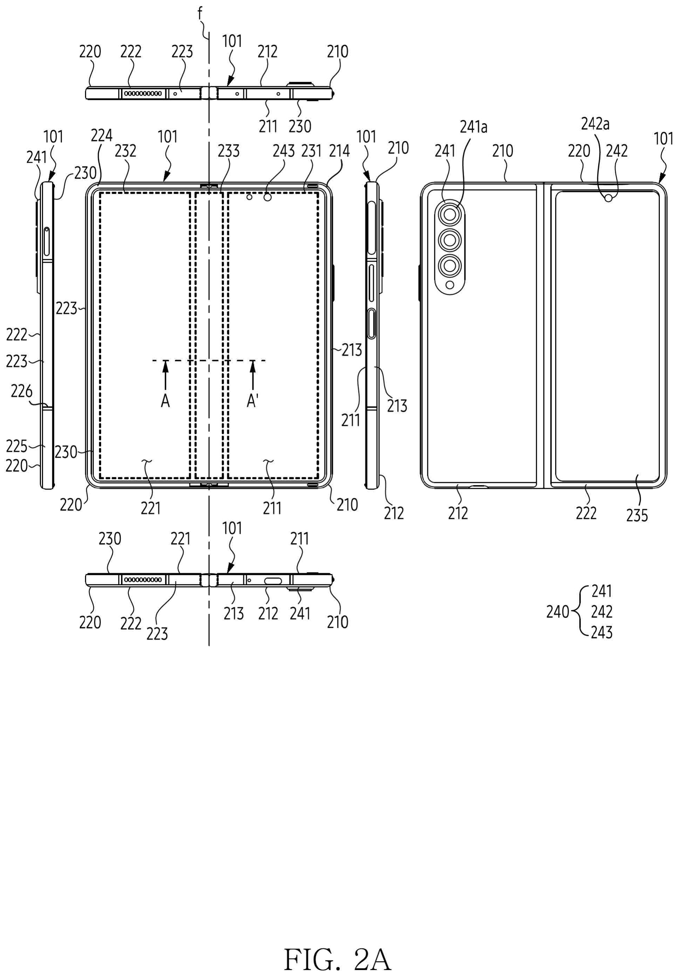

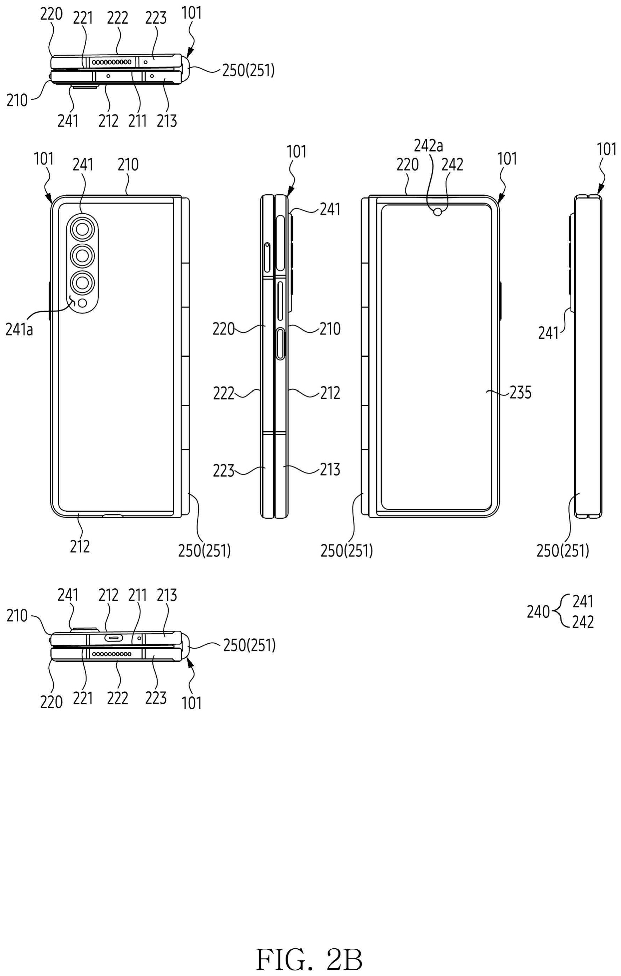

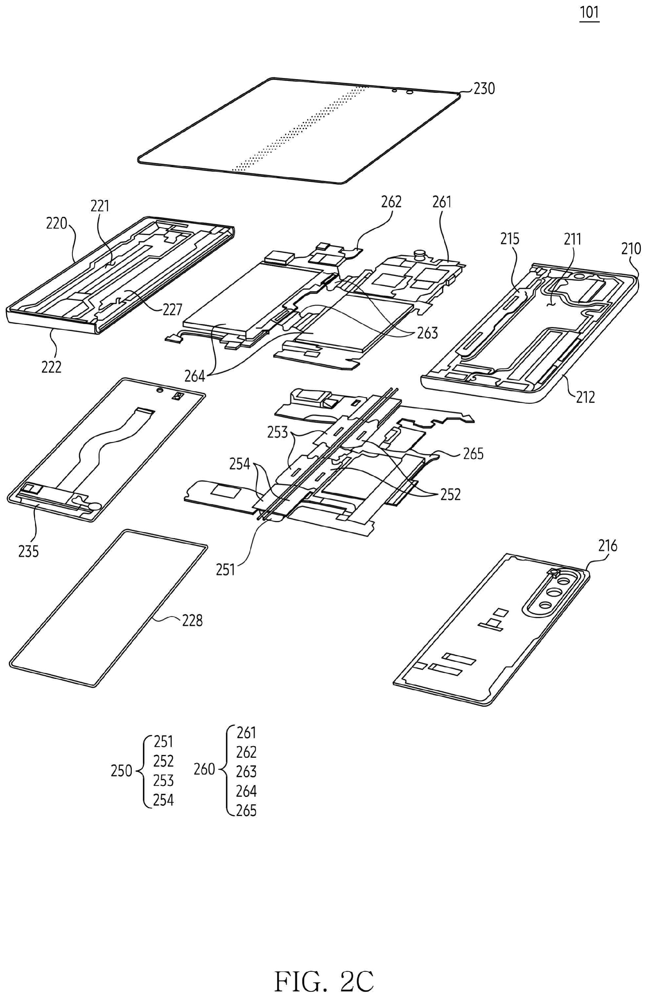

FIG. 2A illustrates an example of an unfolded state of an electronic device according to an embodiment. FIG. 2B illustrates an example of a first folded state of an electronic device according to an embodiment. FIG. 2C is an exploded view of an electronic device according to an embodiment.

Referring to FIGS. 2A, 2B, and 2C, an electronic device 101 may include a first housing 210, a second housing 220, a display 230, at least one camera 240 (e.g., the camera module 180 of FIG. 1), a hinge structure 250, and/or at least one at least one electronic component 260.

The first housing 210 and the second housing 220 may form at least a portion of an outer surface of the electronic device 101 that may be gripped by a user. The at least a portion of the outer surface of the electronic device 101 defined by the first housing 210 and the second housing 220 may contact a portion of a body of the user when the electronic device 101 is used by the user. According to an embodiment, the first housing 210 may include a first front surface 211, a first rear surface 212 facing the first front surface 211 and spaced apart from the first front surface 211, and a first side surface 213 covering at least a portion of the first front surface 211 and the first rear surface 212. The first side surface 213 may connect a periphery of the first front surface 211 to a periphery of the first rear surface 212. The first front surface 211, the first rear surface 212, and the first side surface 213 may define an inner space of the first housing 210. According to an embodiment, the first housing 210 may provide a space formed by the first front surface 211, the first rear surface 212, and the first side surface 213 as a space for disposing components of the electronic device 101.

According to an embodiment, the second housing 220 may include a second front surface 221, a second rear surface 222 facing the second front surface 221 and spaced apart from the second front surface 221, and a second side surface 223 covering at least a portion of the second front surface 221 and the second rear surface 222. The second side surface 223 may connect a periphery of the second front surface 221 to a periphery of the second rear surface 222. The second front surface 221, the second rear surface 222, and the second side surface 223 may define an inner space of the second housing 220. According to an embodiment, the second housing 220 may provide a space formed by the second front surface 221, the second rear surface 222, and the second side surface 223 covering the at least a portion of the second front surface 221 and the second rear surface 222 as a space for mounting components of the electronic device 101. According to an embodiment, the second housing 220 may be coupled to the first housing 210 to be rotatable with respect to the first housing 210.

According to an embodiment, each of the first housing 210 and the second housing 220 may include a first protective member 214 and a second protective member 224, respectively. The first protective member 214 and the second protective member 224 may be disposed on the first front surface 211 and the second front surface 221 along a periphery of the display 230. According to an embodiment, the first protective member 214 and the second protective member 224 may prevent an inflow of a foreign matter (e.g., dust or moisture) through a gap between the display 230 and the first housing 210 and the second housing 220. For example, the first protective member 214 may surround a periphery of a first display region 231 of the display 230, and the second protective member 224 may surround a periphery of a second display region 232 of the display 230. The first protective member 214 may be formed by being attached to the first side surface 213 of the first housing 210, or may be formed integrally with the first side surface 213. The second protective member 224 may be formed by being attached to the second side surface 223 of the second housing 220, or may be formed integrally with the second side surface 223.

According to an embodiment, the first side surface 213 and the second side surface 223 may include a conductive material, a non-conductive material, or a combination thereof. For example, the second side surface 223 may include at least one conductive portion 225 and at least one non-conductive portion 226. The at least one conductive portion 225 may include a plurality of conductive portions spaced apart from each other. The at least one non-conductive portion 226 may be disposed between the plurality of conductive portions. The plurality of conductive portions may be disconnected from each other by the at least one non-conductive portion 226 disposed between the plurality of conductive portions. According to an embodiment, the plurality of conductive portions and a plurality of non-conductive portions may form an antenna radiator together. The electronic device 101 may communicate with an external electronic device through the antenna radiator formed by the plurality of conductive portions and the plurality of non-conductive portions.

The display 230 may be configured to display visual information. According to an embodiment, the display 230 may be disposed on the first front surface 211 of the first housing 210 and the second front surface 221 of the second housing 220 across the hinge structure 250. For example, the display 230 may include the first display region 231 disposed on the first front surface 211 of the first housing, the second display region 232 disposed on the second front surface 221 of the second housing, and a third display region 233 disposed between the first display region 231 and the second display region 232. The first display region 231, the second display region 232, and the third display region 233 may form a front surface of the display 230. According to an embodiment, the display 230 may further include a sub-display panel 235 disposed on the second rear surface 222 of the second housing 220. For example, the display 230 may be referred to as a flexible display. According to an embodiment, the display 230 may include a window exposed toward the outside of the electronic device 101. The window may protect a surface of the display 230 and transmit, by including a substantially transparent material, the visual information provided by the display 230 to the outside of the electronic device 101. For example, the window may include glass (e.g., ultra-thin glass (UTG)) and/or polymer (e.g., polyimide (PI)), but is not limited thereto.

The at least one camera 240 may be configured to obtain an image based on receiving light from an external subject of the electronic device 101. According to an embodiment, the at least one camera 240 may include first cameras 241, a second camera 242, and/or a third camera 243. The first cameras 241 may be disposed in the first housing 210. For example, the first cameras 241 may be disposed inside the first housing 210, and at least a portion may be visible through the first rear surface 212 of the first housing 210. The first cameras 241 may be supported by a bracket (not illustrated) in the first housing 210. The first housing 210 may include at least one opening 241a overlapping the first cameras 241 when the first rear surface 212 is viewed from above. The first cameras 241 may obtain an image based on receiving light from the outside of the electronic device 101 through the at least one opening 241a.

According to an embodiment, the second camera 242 may be disposed in the second housing 220. For example, the second camera 242 may be disposed inside the second housing 220 and may be visible through the sub-display panel 235. The second housing 220 may include at least one opening 242a overlapping the second camera 242 when the second rear surface 222 is viewed from above. The second camera 242 may obtain an image based on receiving light from the outside of the electronic device 101 through the at least one opening 242a.

According to an embodiment, the third camera 243 may be disposed in the first housing 210. For example, the third camera 243 may be disposed inside the first housing 210, and at least a portion may be visible through the first front surface 211 of the first housing 210. For another example, the third camera 243 may be disposed inside the first housing 210, and at least a portion may be visible through the first display region 231 of the display 230. The first display region 231 of the display 230 may include at least one opening (not illustrated) overlapping the third camera 243 when the display 230 is viewed from above. The third camera 243 may obtain an image based on receiving light from the outside of the display 230 through the at least one opening.

According to an embodiment, the second camera 242 and the third camera 243 may be disposed under (e.g., a direction toward the inside of the first housing 210 or the inside of the second housing 220) the display 230. For example, the second camera 242 and the third camera 243 may be an under display camera (UDC). In case that the second camera 242 and the third camera 243 are under display cameras, a region of the display 230 corresponding to a position of each of the second camera 242 and the third camera 243 may not be an inactive region. For example, in case that the second camera 242 and the third camera 243 are under display cameras, a region of the display 230 corresponding to the position of each of the second camera 242 and the third camera 243 may have pixel density lower than pixel density of another region of the display 230. The inactive region of the display 230 may mean a region of the display 230 that does not include a pixel or does not emit light to the outside of the electronic device 101. For another example, the second camera 242 and the third camera 243 may be a punch hole camera. In case that the second camera 242 and the third camera 243 are punch hole cameras, a region of the display 230 corresponding to the position of each of the second camera 242 and the third camera 243 may be the inactive region. For example, when the second camera 242 and the third camera 243 are punch hole cameras, the region of the display 230 corresponding to the position of each of the second camera 242 and the third camera 243 may include an opening that does not include a pixel.

According to an embodiment, the hinge structure 250 may rotatably connect the first housing 210 and the second housing 220. The hinge structure 250 may be disposed between the first housing 210 and the second housing 220 of the electronic device 101 so that the electronic device 101 may be bent, curved, or folded. For example, the hinge structure 250 may be disposed between a portion of the first side surface 213 and a portion of the second side surface 223 facing each other. The hinge structure 250 may change the electronic device 101 into an unfolded (or unfolding) state in which the first front surface 211 of the first housing 210 and the second front surface 221 of the second housing 220 face substantially the same direction as each other, or a folded (or folding) state in which the first front surface 211 and the second front surface 221 face each other. When the electronic device 101 is in a first folded state, the first housing 210 and the second housing 220 may be stacked or overlapped by facing each other.

According to an embodiment, when the electronic device 101 is in the first folded state, a direction in which the first front surface 211 faces and a direction in which the second front surface 221 faces may be different from each other. For example, when the electronic device 101 is in the first folded state, the direction in which the first front surface 211 faces and the direction in which the second front surface 221 faces may be opposite to each other. For another example, when the electronic device 101 is in the first folded state, the direction in which the first front surface 211 faces and the direction in which the second front surface 221 faces may be inclined with respect to each other. When the direction in which the first front surface 211 faces is inclined with respect to the direction in which the second front surface 221 faces, the first housing 210 may be inclined with respect to the second housing 220. However, it is not limited thereto. For example, in the first folded state of the electronic device 101, the first rear surface 212 of the first housing 210 may face the second rear surface 222 of the second housing 220. In case that the first rear surface 212 and the second rear surface 222 face each other in the first folded state of the electronic device 101, the direction in which the first front surface 211 faces and the direction in which the second front surface 221 faces may be opposite to each other. In case that the first rear surface 212 and the second rear surface 222 face each other in the first folded state of the electronic device 101, the display 230 may be directly exposed to the outside in the first folded state of the electronic device 101.

According to an embodiment, the electronic device 101 may be foldable relative to a folding axis f. The folding axis f may mean a virtual line extending through the hinge cover 251 in a direction substantially parallel to a longitudinal direction of the electronic device 101, but it is not limited thereto. For example, the folding axis f may be a virtual line extending in a direction substantially perpendicular to the longitudinal direction of the electronic device 101. In case that the folding axis f extends in the direction substantially perpendicular to the longitudinal direction of the electronic device 101, the hinge structure 250 may connect the first housing 210 and the second housing 220 by extending in a direction parallel to the folding axis f. The first housing 210 and the second housing 220 may be rotatable by the hinge structure 250 extending in the direction substantially perpendicular to the longitudinal direction of the electronic device 101.

According to an embodiment, the hinge structure 250 may include a hinge cover 251, a first hinge plate 252, a second hinge plate 253, and a hinge module 254. The hinge cover 251 may cover internal components of the hinge structure 250 and form an outer surface of the hinge structure 250. According to an embodiment, when the electronic device 101 is in the first folded state, at least a portion of the hinge cover 251 covering the hinge structure 250 may be exposed to the outside of the electronic device 101 through a space between the first housing 210 and the second housing 220. According to an embodiment, when the electronic device 101 is in the unfolded state, the hinge cover 251 may not be exposed to the outside of the electronic device 101 by being covered by the first housing 210 and the second housing 220.

According to an embodiment, the first hinge plate 252 and the second hinge plate 253 may rotatably connect the first housing 210 and the second housing 220 by being coupled to the first housing 210 and the second housing 220, respectively. For example, the first hinge plate 252 may be coupled with a first front bracket 215 of the first housing 210, and the second hinge plate 253 may be coupled with a second front bracket 227 of the second housing 220. As the first hinge plate 252 and the second hinge plate 253 are coupled to the first front bracket 215 and the second front bracket 227, respectively, the first housing 210 and the second housing 220 may be rotatable according to rotation of the first hinge plate 252 and the second hinge plate 253.

The hinge module 254 may rotate the first hinge plate 252 and the second hinge plate 253. For example, the hinge module 254 may rotate the first hinge plate 252 and the second hinge plate 253 relative to the folding axis f, by including gears that are rotatable by being engaged with each other. According to an embodiment, the hinge module 254 may be plural. For example, the plurality of hinge modules 254 may be disposed to be spaced apart from each other at both ends of the first hinge plate 252 and the second hinge plate 253, respectively.

According to an embodiment, the first housing 210 may include the first front bracket 215 and a first rear bracket 216, and the second housing 220 may include the second front bracket 227 and a second rear bracket 228. The first front bracket 215 and the first rear bracket 216 may support components of the electronic device 101. The first front bracket 215 may define the first housing 210 by being coupled to the first rear bracket 216. The first rear bracket 216 may define a portion of an outer surface of the first housing 210. The second front bracket 227 and the second rear bracket 228 may support components of the electronic device 101. The second front bracket 227 may define the second housing 220 by being coupled to the second rear bracket 228. The second rear bracket 228 may define a portion of an outer surface of the second housing 220. For example, the display 230 may be disposed on a surface of the first front bracket 215 and a surface of the second front bracket 227. The first rear bracket 216 may be disposed on another surface of the first front bracket 215 opposite to the surface of the first front bracket 215. The second rear bracket 228 may be disposed on another surface of the second front bracket 227 opposite to the surface of the second front bracket 227. The sub-display panel 235 may be disposed between the second front bracket 227 and the second rear bracket 228.

According to an embodiment, a portion of the first front bracket 215 may be surrounded by the first side surface 213, and a portion of the second front bracket 227 may be surrounded by the second side surface 223. For example, the first front bracket 215 may be integrally formed with the first side surface 213, and the second front bracket 227 may be integrally formed with the second side surface 223. For another example, the first front bracket 215 may be formed separately from the first side surface 213, and the second front bracket 227 may be formed separately from the second side surface 223.

The at least one at least one electronic component 260 may implement various functions to be provided to the user. According to an embodiment, the at least one at least one electronic component 260 may include a first printed circuit board 261, a second printed circuit board 262, a flexible printed circuit board 263, a battery 264 (e.g., the battery 189 of FIG. 1), and/or an antenna 265 (e.g., the antenna module 197 of FIG. 1). The first printed circuit board 261 and the second printed circuit board 262 may each form an electrical connection between components in the electronic device 101. For example, components (e.g., the processor 120 of FIG. 1) for implementing an overall function of the electronic device 101 may be disposed in the first printed circuit board 261, and at least one electronic components for implementing some functions of the first printed circuit board 261 may be disposed in the second printed circuit board 262. For another example, components for an operation of the sub-display panel 235 disposed on the second rear surface 222 may be disposed in the second printed circuit board 262.

According to an embodiment, the first printed circuit board 261 may be disposed in the first housing 210. For example, the first printed circuit board 261 may be disposed on a surface of the first front bracket 215. According to an embodiment, the second printed circuit board 262 may be disposed in the second housing 220. For example, the second printed circuit board 262 may be spaced apart from the first printed circuit board 261 and disposed on a surface of the second front bracket 227. The flexible printed circuit board 263 may connect the first printed circuit board 261 and the second printed circuit board 262. For example, the flexible printed circuit board 263 may extend from the first printed circuit board 261 to the second printed circuit board 262.

The battery 264 is a device for supplying power to at least one component of the electronic device 101, and may include, for example, a non-rechargeable primary battery, a rechargeable secondary battery, or a fuel cell. At least a portion of the battery 264 may be disposed on substantially the same plane as the first printed circuit board 261 or the second printed circuit board 262.

The antenna 265 may be configured to receive power or a signal from the outside of the electronic device 101. According to an embodiment, the antenna 265 may be disposed between the first rear bracket 216 and the battery 264. The antenna 265 may include, for example, a near field communication (NFC) antenna, an antenna module, and/or a magnetic secure transmission (MST) antenna. The antenna 265 may, for example, perform short-range communication with an external device or wirelessly transmit and receive power required for charging.

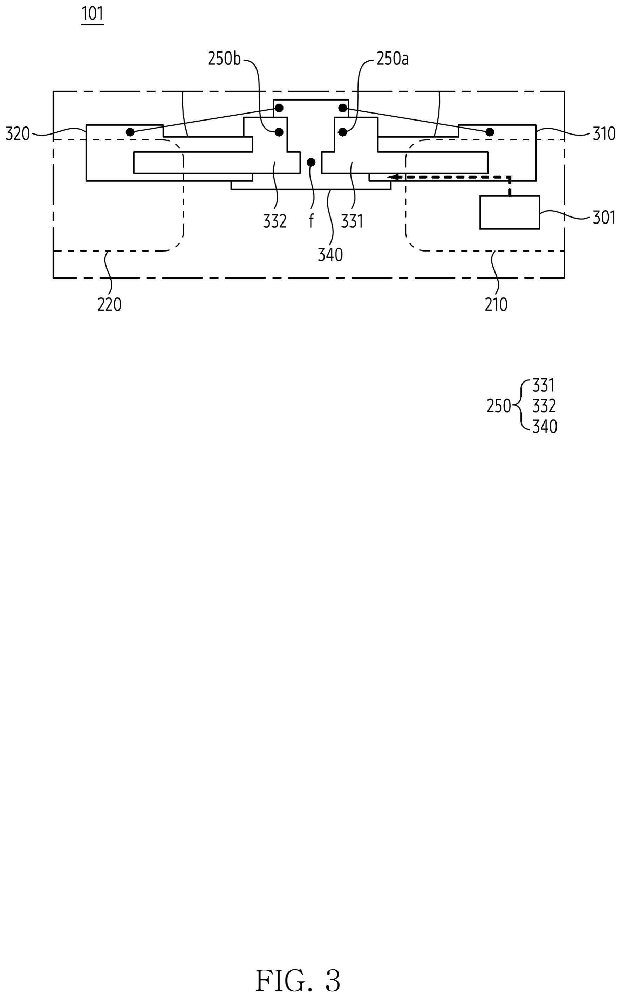

FIG. 3 is a partial cross-sectional view of an exemplary electronic device cut along line A-A' of FIG. 2A.

Referring to FIG. 3, an electronic device 101 may include a first housing 210, a second housing 220, at least one electronic component 301, and a hinge structure 250.

According to an embodiment, the first housing 210 may include a first supporting portion 310. The second housing 220 may include a second supporting portion 320 facing the first supporting portion 310.

For example, the first supporting portion 310 may be a portion of the first housing 210 coupled to the hinge structure 250. For example, the first supporting portion 310 may be configured to rotate the first housing 210 with respect to the hinge structure 250, by being rotatably coupled to the hinge structure 250. For example, the first supporting portion 310 may be a bracket (e.g., the first front bracket 215 of FIG. 2C) in the first housing 210 to be coupled to the hinge structure 250, but is not limited thereto. For example, the first supporting portion 310 may be configured to deform at least a portion (e.g., the third display region 233 of FIG. 2A) of a display (e.g., the display 230 of FIG. 2A) on the first housing 210, by rotatably coupling the first housing 210 to the hinge structure 250. For example, the first supporting portion 310 may receive at least a portion of heat emitted from the at least one electronic component 301 in the first housing 210.

For example, the second supporting portion 320 may be a portion of the second housing 220 coupled to the hinge structure 250. For example, the second supporting portion 320 may be configured to rotate the second housing 220 with respect to the hinge structure 250, by being rotatably coupled to the hinge structure 250. For example, the second supporting portion 320 may be a bracket (e.g., the second front bracket 227 of FIG. 2C) in the second housing 220 to be coupled to the hinge structure 250, but is not limited thereto. For example, the second supporting portion 320 may be configured to deform at least a portion (e.g., the third display region 233 of FIG. 2A) of the display 230 on the second housing 220, by rotatably coupling the second housing 220 to the hinge structure 250.

According to an embodiment, the electronic device 101 may include the display 230 including a first display region (e.g., the first display region 231 of FIG. 2A) coupled to the first housing 210, a second display region (e.g., the second display region 232 of FIG. 2A) coupled to the second housing 220, and the third display region 233, which is deformable, extending from the first display region 231 to the second display region 232. For example, the first display region 231 may be attached on the first housing 210. The second display region 232 may be attached on the second housing 220 and spaced apart from the first display region 231. For example, the third display region 233 may connect the first display region 231 and the second display region 232. The third display region 233 may be disposed on the hinge structure 250. For example, the third display region 233 may be at least partially deformed by the first housing 210 and/or the second housing 220 that are rotated by the hinge structure 250. For example, the third display region 233 may be disposed on the first supporting portion 310 of the first housing 210 and the second supporting portion 320 of the second housing 220. The third display region 233 may be at least partially deformed by the first supporting portion 310 and/or the second supporting portion 320. The display 230 may provide various user experiences to a user by including the deformable third display region 233.

According to an embodiment, the at least one electronic component 301 may be disposed in the first housing 210. For example, the at least one electronic component 301 may be disposed on a printed circuit board (e.g., the first printed circuit board 261 of FIG. 2C) in the first housing 210. For example, the at least one electronic component 301 may be disposed between the first housing 210 and the display 230 on the first housing 210. For example, as the electronic device 101 operates, the at least one electronic component 301 may emit heat. At least a portion of the heat emitted from the electronic device 101 may be transferred to the first supporting portion 310 of the first housing 210. For example, the at least one electronic component 301 may be referred to as a processor (e.g., the processor 120 of FIG. 1) and/or a battery (e.g., the battery 189 of FIG. 1(the battery 189 of FIG. 1) and/or the battery 264 of FIG. 2C) of the electronic device 101, but it is not limited thereto.

According to an embodiment, the hinge structure 250 may be configured to provide a plurality of folded states in which the second housing 220 is folded relative to a folding axis f with respect to the first housing 210 and an unfolded state by rotatably coupling the first supporting portion 310 and the second supporting portion 320.

The plurality of folded states of the electronic device 101 may mean states in which the second housing 220 is folded by the hinge structure 250 with respect to the first housing 210. For example, the plurality of folded states may be states in which the second housing 220 is inclined with respect to the first housing 210. For example, the plurality of folded states may be states in which a second front surface (e.g., the second front surface 221 of FIG. 2A) of the second housing 220 is inclined with respect to a first front surface (e.g., the first front surface 211 of FIG. 2A) of the first housing 210. The plurality of folded states may be states in which the first front surface 211 and the second front surface 221 face each other. The plurality of folded states may be states in which the first front surface 211 and the second front surface 221 face substantially different directions. For example, the plurality of folded states may be states in which the first display region 231 on the first housing 210 of the display 230 faces a different direction from the second display region 232 on the second housing 220. For example, the plurality of folded states may be in a state in which at least a portion of the third display region 233 between the first display region 231 and the second display region is bent. For example, the plurality of folded states may include states in which an angle between the first housing 210 and the second housing 220 is positioned within a range that is more than 0 degrees and less than 180 degrees.

The unfolded state of the electronic device 101 may be referred to as a state in which the first housing 210 and the second housing 220 are unfolded. For example, the unfolded state may be a state that may be changed to the plurality of folded states. For example, the unfolded state may be a state in which the first housing 210 and the second housing 220 form a substantially flat surface as the first housing 210 and the second housing 220 are unfolded. For example, the unfolded state may be a state in which the first display region 231 and the second display region 232 of the display 230 face substantially the same direction. For example, the unfolded state may be a state in which an angle between the first housing 210 and the second housing 220 is 180 degrees. For example, the unfolded state may be a state in which the deformable third display region 233 of the display 230 is unfolded.

For example, the hinge structure 250 may provide a folding axis f. The first supporting portion 310 may be coupled to the hinge structure 250 so as to be rotatable with respect to the second supporting portion 320 relative to the folding axis f. The second supporting portion 320 may be coupled to the hinge structure 250 so as to be rotatable with respect to the first supporting portion 310 relative to the folding axis f. For example, the first housing 210 may be coupled to the hinge structure 250 so as to be rotatable with respect to the second housing 220 through the first supporting portion 310. The second housing 220 may be coupled to the hinge structure 250 so as to be rotatable with respect to the first housing 210 through the second supporting portion 320. For example, the first supporting portion 310 and the second supporting portion 320 may face each other relative to the folding axis f.

According to an embodiment, the hinge structure 250 may include a first hinge plate 331 coupled to the first housing 210, and a second hinge plate 332 coupled to the second housing 220 and spaced apart from the first hinge plate 331. The hinge structure 250 may include a hinge cover 340 rotatably connecting the first hinge plate 331 and the second hinge plate 332. For example, the hinge cover 340 may include a first link 250a for coupling the first hinge plate 331 to the hinge cover 340, and a second link 250b for coupling the second hinge plate 332 to the hinge cover 340. The first link 250a may provide a rotation axis such that the first hinge plate 331 is rotatable relative to the hinge cover 340. The second link 250b may provide a rotation axis such that the second hinge plate 332 is rotatable relative to the hinge cover 340. The hinge cover 340 may rotatably couple the first hinge plate 331 and the second hinge plate 332 by providing the first link 250a and the second link 250b. For example, the first hinge plate 331 may be coupled to the first supporting portion 310 of the first housing 210. The second hinge plate 332 may be coupled to the second supporting portion 320 of the second housing 220. For example, the first hinge plate 331 and the second hinge plate 332 may face each other relative to the folding axis f. For example, the hinge cover 340 may be a portion of the hinge structure 250 that provides the folding axis f. For example, the hinge cover 340 may be at least partially disposed between the first housing 210 and the second housing 220. For example, the hinge cover 340 may be at least partially exposed to the outside in the plurality of folded states of the electronic device 101. For example, the hinge cover 340 may rotatably couple the first hinge plate 331 and the second hinge plate 332 by including a hinge module (e.g., the hinge module 254 of FIG. 2C) including at least one gear in the hinge structure 250. The hinge cover 340 may rotatably couple the first housing 210 and the second housing 220 by rotatably coupling the first hinge plate 331 and the second hinge plate 332.

According to an embodiment, the first supporting portion 310 may be slidably coupled to the first hinge plate 331. The second supporting portion 320 may be slidably coupled to the second hinge plate 332. For example, the first supporting portion 310 may slide toward the folding axis f with respect to the first hinge plate 331 while changing from the plurality of folded states to the unfolded state. The second supporting portion 320 may slide toward the folding axis f with respect to the first hinge plate 331 while changing from the plurality of folded states to the unfolded state. For example, in order to change from the unfolded state to the plurality of folded states, the first supporting portion 310 may slide in a direction opposite to a direction toward the folding axis f with respect to the first hinge plate 331 in the unfolded state. The second supporting portion 320 may slide in a direction opposite to a direction toward the folding axis f with respect to the second hinge plate 332 in the unfolded state. However, it is not limited thereto.

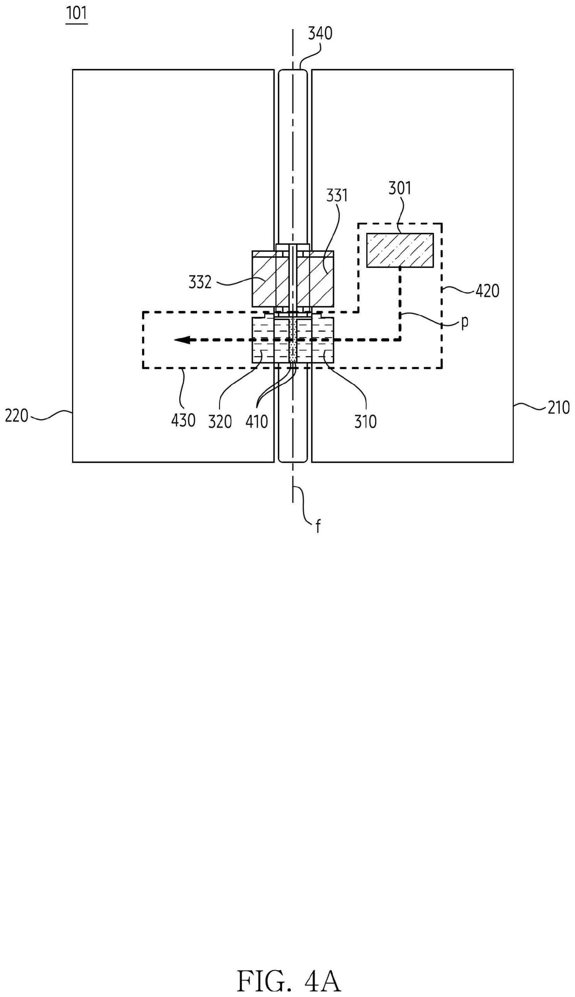

According to an embodiment, heat emitted from the at least one electronic component 301 in the first housing 210 may be emitted into the inside of the first housing 210. Due to the heat, performance of at least one electronic components in the first housing 210 and/or the electronic device 101 may be degraded. At least a portion of the heat may be transferred to the first supporting portion 310 of the first housing 210. The electronic device 101 may be required to have a structure for dissipating the heat using the first supporting portion 310 and the second supporting portion 320 facing the first supporting portion 310. The structure for dissipating the heat will be described below in FIG. 4A.

According to the above-described embodiment, the electronic device 101 may provide various user experiences to the user by including the first housing 210 having the first supporting portion 310 coupled to the hinge structure 250 and the second housing 220 having the second supporting portion 320 coupled to the hinge structure 250. The electronic device 101 may provide various user experiences to the user by including the display 230 including the deformable third region 233.

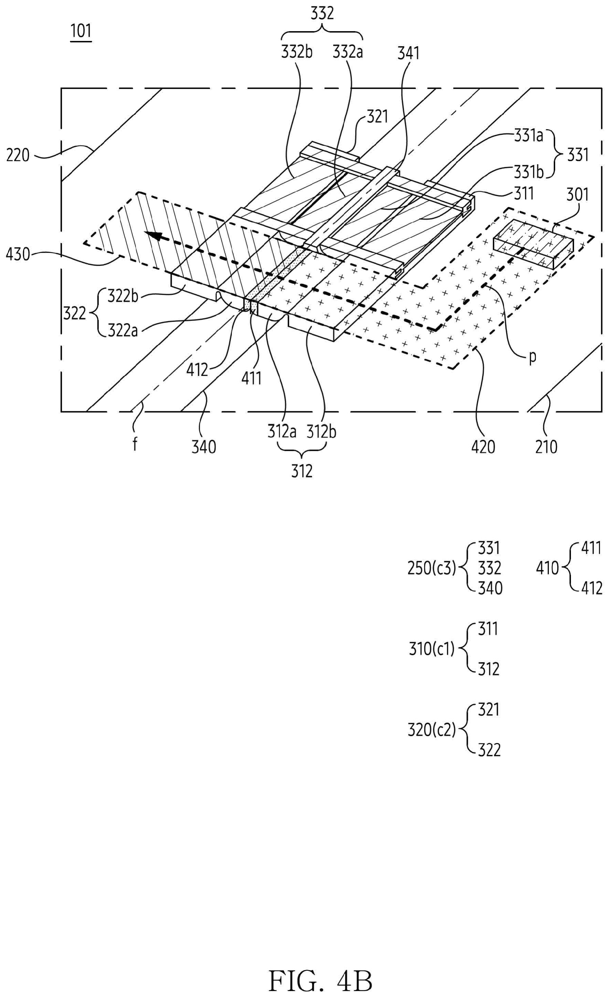

FIGS. 4A and 4B illustrate a portion of an exemplary electronic device.

Referring to FIGS. 4A and 4B, an electronic device 101 may include a first housing 210 including a first supporting portion 310 and a second housing 220 including a second supporting portion 320 facing the first supporting portion 310. The electronic device 101 may include at least one electronic component 301 in the first housing 210. The electronic device 101 may include a hinge structure 250 configured to provide a plurality of folded states in which the second housing 220 is folded relative to a folding axis f with respect to the first housing 210 and an unfolded state by rotatably coupling the first supporting portion 310 and the second supporting portion 320. According to an embodiment, the hinge structure 250 may include a first hinge plate 331 coupled to the first housing 210, a second hinge plate 332 coupled to the second housing 220 and spaced apart from the first hinge plate 331, and a hinge cover 340 rotatably connecting the first hinge plate 331 and the second hinge plate 332.

According to an embodiment, the first hinge plate 331 may be coupled to the first supporting portion 310. The second hinge plate 332 may be coupled to the second supporting portion 320. The hinge cover 340 may include a first protruding structure 341 on the folding axis f separating the first hinge plate 331 and the second hinge plate 332. For example, the first protruding structure 341 may overlap the folding axis f. The first hinge plate 331 and the second hinge plate 332 may contact the first protruding structure 341 in the unfolded state. For example, the first hinge plate 331 may include a first coupling portion 331a coupled to the hinge cover 340, and a second coupling portion 331b extending from the first coupling portion 331a toward the first housing 210 and coupled to the first supporting portion 310. The second hinge plate 332 may include a third coupling portion 332a coupled to the hinge cover 340, and a fourth coupling portion 332b extending from the third coupling portion 332a toward the second housing 220 and coupled to the second supporting portion 320. The first coupling portion 331a and the third coupling portion 332a may each be rotatably coupled to the hinge cover 340. The first coupling portion 331a and the third coupling portion 332a may contact the first protruding structure 341 in the unfolded state. The second coupling portion 331b may be slidably coupled to the first supporting portion 310. The fourth coupling portion 332b may be slidably coupled to the second supporting portion 320.

According to an embodiment, the first supporting portion 310 may be configured to form a heat transfer path p from the at least one electronic component 301 to the second housing 220 by being connected with the second supporting portion 320 in the unfolded state.

For example, the first supporting portion 310 may be contacted with the second supporting portion 320 in the unfolded state. For example, the first supporting portion 310 may be disposed to be closer to the second supporting portion 320 in the unfolded state than in the plurality of folded states. For example, the first supporting portion 310 may receive heat from the at least one electronic component 301 in the first housing 210. The first supporting portion 310 may transfer, through conduction heat transfer to the second supporting portion 320 in the unfolded state, at least a portion of the heat received from the at least one electronic component 301 to the second supporting portion 320. For example, in the unfolded state, at least a portion of the first supporting portion 310 may contact at least a portion of the second supporting portion 320 on the hinge cover 340. For example, the first supporting portion 310 may form the heat transfer path p with the second supporting portion 320 through at least one thermally conductive material disposed between the first supporting portion 310 and the second supporting portion 320 in the unfolded state. Since the at least a portion of the heat is transferred to the second supporting portion 320, heat emitted from the at least one electronic component 301 into the inside of the first housing 210 may be dissipated into the inside of the second housing 220 through the heat transfer path p formed by the first supporting portion 310 and the second supporting portion 320. The first supporting portion 310 may reduce damage to the electronic device 101 by heat emitted from the at least one electronic component 301, by forming the heat transfer path p together with the second supporting portion 320 in the unfolded state.

According to an embodiment, the first supporting portion 310 may be slidably coupled to the first hinge plate 331. The first supporting portion 310 may include a first portion 311 supporting the first hinge plate 331 and a second portion 312 extending from the first portion 311 along the folding axis f. The second supporting portion 320 may be slidably coupled to the second hinge plate 332. The second supporting portion 320 may include a third portion 321 supporting the second hinge plate 332, and a fourth portion 322 extending from the third portion 321 along the folding axis f. The second portion 312 may be configured to form the heat transfer path p by contacting the fourth portion 322 in the unfolded state.

For example, the first portion 311 may be a portion of the first supporting portion 310 coupled to the first hinge plate 331. The first portion 311 may be slidably coupled to the first hinge plate 331. For example, the first portion 311 may be a portion of the first supporting portion 310 contacting the first hinge plate 331. The first portion 311 may cover at least a portion of the first hinge plate 331. The first portion 311 may be spaced apart from the second supporting portion 320 by the hinge cover 340 (or the first protruding structure 341) by being coupled to the first hinge plate 331. For example, the second portion 312 may be connected to the first portion 311. The second portion 312 may extend from the first housing 210 toward the folding axis f in the unfolded state.

For example, the third portion 321 may be a portion of the second supporting portion 320 coupled to the second hinge plate 332. The third portion 321 may be slidably coupled to the second hinge plate 332. For example, the third portion 321 may be a portion of the second supporting portion 320 contacting the second hinge plate 332. The third portion 321 may cover at least a portion of the second hinge plate 332. The third portion 321 may be spaced apart from the first supporting portion 310 by the hinge cover 340 (or the first protruding structure 341) by being coupled to the second hinge plate 332. For example, the fourth portion 322 may be connected to the third portion 321. The fourth portion 322 may extend from the second housing 220 toward the folding axis f in the unfolded state.

For example, the second portion 312 may contact the fourth portion 322 on the folding axis f in the unfolded state. The second portion 312 may be disconnected from the fourth portion 322 by being spaced apart from the fourth portion 322 in the plurality of folded states. For example, the electronic device 101 may be configured to maintain a low power mode of a display (e.g., the display 230 of FIG. 2A) in the plurality of folded states. The electronic device 101 may be configured to emit relatively more heat from the at least one electronic component 301 in the unfolded state than in the plurality of folded states, in order to display visual information through the display 230. The second portion 312 may form the heat transfer path p for the heat emitted from the at least one electronic component 301 by contacting the fourth portion 322 in the unfolded state.

For example, the second portion 312 may include a first region 312a disposed on the hinge cover 340 in the unfolded state. The fourth portion 322 may include a second region 322a disposed on the hinge cover 340 and contacting the first region 312a in the unfolded state. For example, while changing from the plurality of folded states to the unfolded state, the first region 312a may be positioned on the hinge cover 340 by moving along the first supporting portion 310 sliding with respect to the first hinge plate 331. While changing from the plurality of folded states to the unfolded state, the second region 322a may be positioned on the hinge cover 340 by moving along the second supporting portion 320 sliding with respect to the second hinge plate 332. The first region 312a and the second region 322a may contact on the hinge cover 340 in the unfolded state. For example, the second portion 312 may include a third region 312b extending from the first portion 311. The first region 312a may protrude from the third region 312b toward the folding axis f in the unfolded state. For example, the fourth portion 322 may include a fourth region 322b extending from the third portion 321. The second region 322a may protrude from the fourth region 322b toward the folding axis f in the unfolded state. In the unfolded state, the first region 312a may contact the second region 322a relative to the folding axis f. As the first region 312a is configured to contact the second region 322a in the unfolded state, the electronic device 101 may dissipate heat emitted from the at least one electronic component 301 to the second housing 220 through the heat transfer path p formed by the first region 312a and the second region 322a.

According to an embodiment, the first region 312a and the second region 322a may each include a deformable first heat conducting member 410. For example, the first heat conducting member 410 may be disposed in a portion of the second region 322a contacting the first region 312a and a portion of the first region 312a contacting the second region 322a in the unfolded state. For example, the first heat conducting member 410 may be disposed along the folding axis f in the unfolded state. For example, the first heat conducting member 410 may form a surface of the second region 322a configured to contact the first region 312a. The first heat conducting member 410 may form a surface of the first region 312a configured to contact the surface of the second region 322a. For example, the first heat conducting member 410 may increase thermal conduction efficiency of the heat transfer path p by having a relatively high thermal conductivity. For example, as the first heat conducting member 410 is deformable, it may reduce damage to the second portion 312 and the fourth portion 322 by contacting the second portion 312 and the fourth portion 322 while changing from the plurality of folded states to the unfolded state.

According to an embodiment, the first heat conducting member 410 may include a first heat conduction part 411 disposed in the first region 312a and a second heat conduction part 412 disposed in the second region 322a. The first heat conduction part 411 may contact the second heat conduction part 412 in the unfolded state. For example, the first heat conduction part 411 may be disposed at an end of the first region 312a facing the second region 322a in the unfolded state. The second heat conduction part 412 may be disposed at an end of the second region 322a facing the first region 312a in the unfolded state. For example, the first heat conduction part 411 may receive heat from the at least one electronic component 301. Since the first heat conduction part 411 contacts the second heat conduction part 412 in the unfolded state, the heat transferred from the at least one electronic component 301 to the first heat conduction part 411 may be transferred to the second housing 220 through the second heat conduction part 412.

According to an embodiment, the first supporting portion 310 and the second supporting portion 320 may each include at least one of aluminum, thermal grease, and SMT gasket. For example, the first heat conducting member 410 included in the first supporting portion 310 and the second supporting portion 320 and forming the heat transfer path p may reduce, by including at least one of thermal grease and SMT gasket, thermal resistance between the first supporting portion 310 and the second supporting portion 320. For example, the first supporting portion 310 and the second supporting portion 320 may increase, by each including aluminum, a thermal conductivity for the heat transfer path p from the at least one electronic component 301 to the second housing 220. However, it is not limited thereto.

According to an embodiment, a thermal conductivity c1 of the first supporting portion 310 and a thermal conductivity c2 of the second supporting portion 320 may be greater than a thermal conductivity c3 of the hinge structure 250. Since the thermal conductivity c1 of the first supporting portion 310 and the thermal conductivity c2 of the second supporting portion 320 are higher than the thermal conductivity c3 of the hinge structure 250, the electronic device 101 may increase the thermal conduction efficiency of the heat transfer path p formed by the first supporting portion 310 and the second supporting portion 320 in the unfolded state. For example, the first supporting portion 310 and the second supporting portion 320 may form the heat transfer path p from the at least one electronic component 301 to the second housing 220 by being contacted with each other over the hinge structure 250. The first supporting portion 310 and the second supporting portion 320 may increase thermal conduction efficiency of a heat transfer path of the heat transfer path p by being directly contacted with each other without passing through the hinge structure 250.

According to an embodiment, the electronic device 101 may include a vapor chamber 420 in the first housing 210 contacting the at least one electronic component 301 and the first supporting portion 310, and forming a heat transfer path p by extending from the at least one electronic component 301 to the first supporting portion 310. For example, the vapor chamber 420 may be positioned at least partially on the at least one electronic component 301. For example, the vapor chamber 420 may be attached to the at least one electronic component 301. For example, the vapor chamber 420 may provide the heat transfer path in the first housing 210 for heat transfer from the at least one electronic component 301 to the first supporting portion 310. For example, the vapor chamber 420 may extend to a portion (e.g., the first region 312a) of the first supporting portion 310 contacting the second supporting portion 320 in the unfolded state. For example, the vapor chamber 420 may extend from the at least one electronic component 301 to the folding axis f in the unfolded state. The electronic device 101 may be configured to form the heat transfer path for heat transfer from the at least one electronic component 301 in the first housing 210 to the portion (e.g., the first region 312a) of the first supporting portion 310, by including the vapor chamber 420 in the first housing 210.

According to an embodiment, the second housing 220 may include a heat dissipation member 430 attached to the second supporting portion 320 and configured to contact the vapor chamber 420 in the unfolded state. For example, the heat dissipation member 430 may cover at least a portion of the second supporting portion 320. For example, the heat dissipation member 430 may extend from the second supporting portion 320 to the inside of the second housing 220. For example, the heat dissipation member 430 may extend to the folding axis f in the unfolded state. For example, the heat dissipation member 430 may contact the vapor chamber 420 on the folding axis f in the unfolded state. The heat dissipation member 430 may dissipate heat received, in the unfolded state, from the vapor chamber 420, the first supporting portion 310, the second supporting portion 320, and/or the first heat conducting member 410 into the inside of the second housing 220. The electronic device 101 may form the heat transfer path p from the at least one electronic component 301 of the first housing 210 to the second housing 220 by including the heat dissipation member 430 disposed in the second housing 220.

It is described and illustrated that the electronic device 101 includes the vapor chamber 420 in the first housing 210 and the heat dissipation member 430 in the second housing 220, but it is not limited thereto. The electronic device 101 may include at least one of a plurality of vapor chambers, a plurality of heat dissipation members, and a combination thereof in order to form the heat transfer path p of the heat emitted from the at least one electronic component 301 in the first housing 210. For example, unlike the illustration, the second housing 220 may include another vapor chamber distinct from the vapor chamber 420 positioned in the first housing 210 instead of the heat dissipation member 430. The other vapor chamber may form the heat transfer path p from the at least one electronic component 301 to the second housing 220 together with the vapor chamber 420, in the unfolded state. For example, unlike the illustration, the first housing 220 may include another heat dissipation member distinct from the heat dissipation member 430 disposed in the second housing 220 instead of the vapor chamber 420. The other heat dissipation member may form the heat transfer path p from the at least one electronic component 301 to the second housing 220 together with the heat dissipation member 430, in the unfolded state.

According to the above-described embodiment, as the first supporting portion 310 of the first housing 210 and the second supporting portion 320 of the second housing 220 are configured to form the heat transfer path p in the unfolded state, the electronic device 101 may be configured to dissipate at least a portion of the heat emitted from the at least one electronic component 301 in the first housing 210 to the second housing 220 in the unfolded state. The electronic device 101 may reduce damage to the electronic device 101 by the heat emitted from the at least one electronic component 301 by being configured to form the heat transfer path p in the unfolded state.

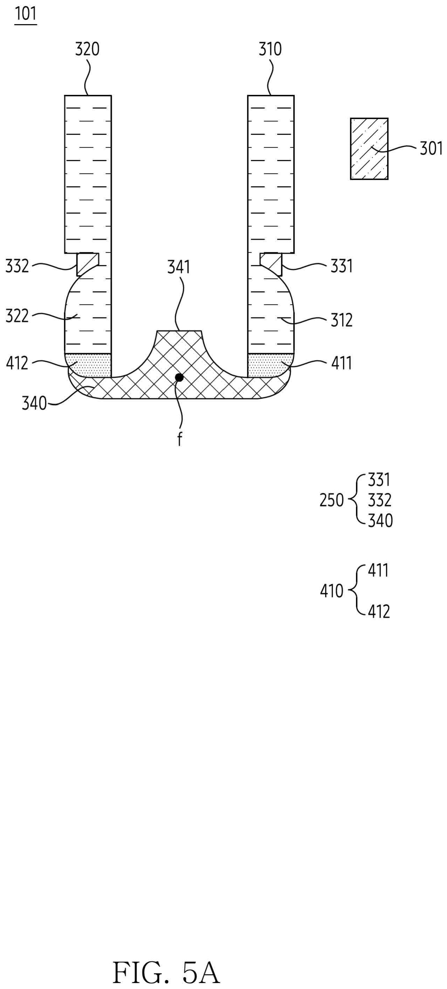

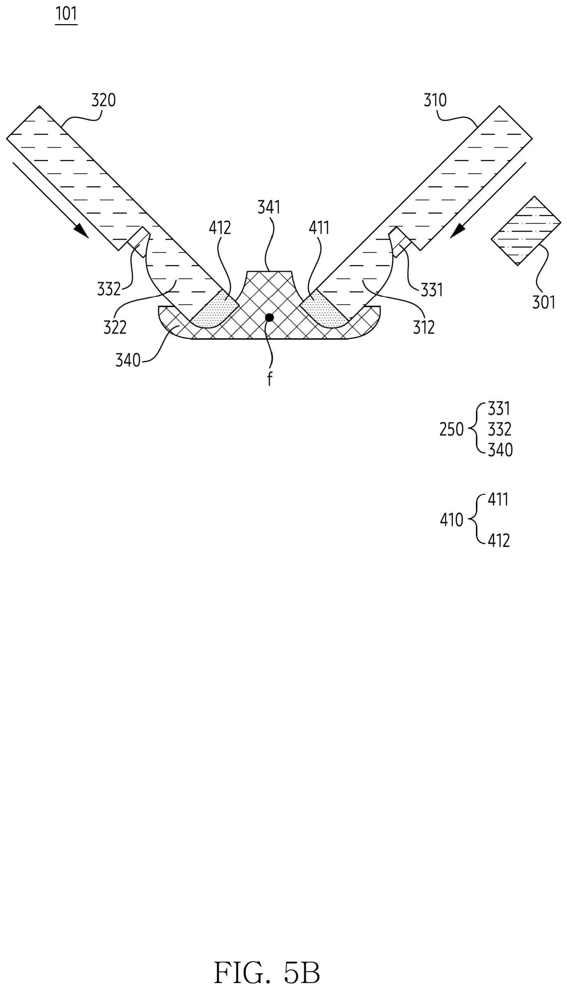

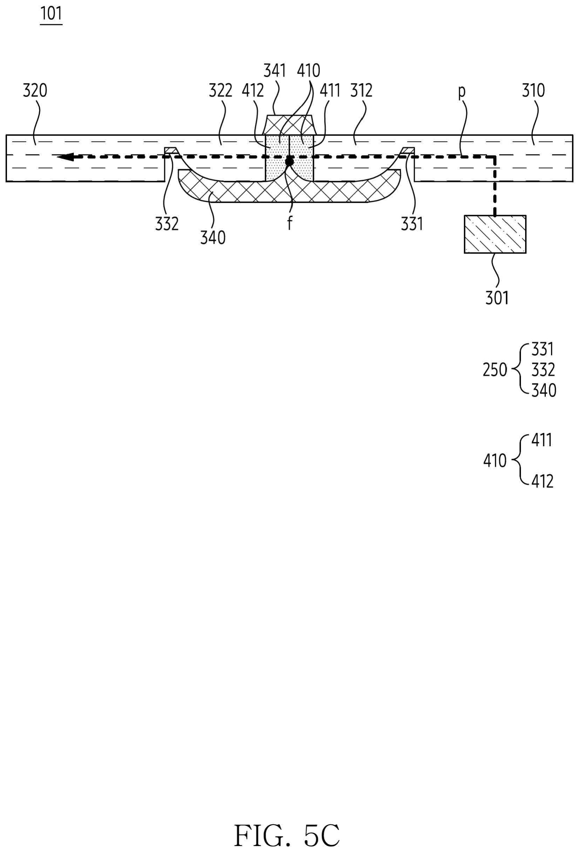

FIG. 5A illustrates a portion of an exemplary electronic device in a first folded state. FIG. 5B illustrates a portion of an exemplary electronic device in a second folded state. FIG. 5C illustrates a portion of an exemplary electronic device in an unfolded state.

Referring to FIGS. 5A, 5B, and 5C, an electronic device 101 may include a first housing (e.g., the first housing 210 of FIG. 2A) including a first supporting portion 310 and a second housing (e.g., the second housing 220 of FIG. 2A) including a second supporting portion 320 facing the first supporting portion 310. The electronic device 101 may include at least one electronic component 301 in the first housing 210. The electronic device 101 may include a hinge structure 250 configured to provide a plurality of folded states in which the second housing 220 is folded relative to a folding axis f with respect to the first housing 210 and an unfolded state by rotatably coupling the first supporting portion 310 and the second supporting portion 320. The first supporting portion 310 may be configured to form a heat transfer path p from the at least one electronic component 301 to the second housing 220 by being connected to the second supporting portion 320 in the unfolded state. According to an embodiment, the hinge structure 250 may include a first hinge plate 331 coupled to the first housing 210, a second hinge plate 332 coupled to the second housing 220 and spaced apart from the first hinge plate 331, and a hinge cover 340 rotatably connecting the first hinge plate 331 and the second hinge plate 332.

Hereinafter, redundant descriptions of configurations having the same reference numerals described in FIGS. 4A and 4B will be omitted.

According to an embodiment, a second portion 312 may contact a fourth portion 322 on the folding axis f in the unfolded state. The second portion 312 may be disconnected from the fourth portion 322 by being spaced apart from the fourth portion 322 in the plurality of folded states.

Referring to FIGS. 5A and 5B, the first supporting portion 310 may be disconnected from the second supporting portion 320 in the plurality of folded states including the first folded state and the second folded state. While changing from the first folded state to the second folded state, the first hinge plate 331 may rotate with respect to the hinge cover 340. The first supporting portion 310 may slide toward the folding axis f with respect to the first hinge plate 331 by moving along the first hinge plate 331 that rotates with respect to the hinge cover 340. The at least one electronic component 301 in the first housing 210 may be rotated along the first supporting portion 310 that moves with respect to the hinge structure 250. While changing from the first folded state to the second folded state, the second hinge plate 332 may rotate with respect to the hinge cover 340. The second supporting portion 320 may slide toward the folding axis f with respect to the second hinge plate 332 by moving along the second hinge plate 332 that rotates with respect to the hinge cover 340.

Referring to FIGS. 5B and 5C, while changing from the second folded state to the unfolded state, the first supporting portion 310 may be moved toward the second supporting portion 320 by sliding toward the folding axis f with respect to the first hinge plate 331. The second supporting portion 320 may be moved toward the first supporting portion 310 by sliding toward the folding axis f with respect to the second hinge plate 332. In the unfolded state, the first supporting portion 310 and the second supporting portion 320 may form the heat transfer path p from the at least one electronic component 301 to the second housing 220 by being contacted with each other on the folding axis f. The first hinge plate 331 and the second hinge plate 332 may be spaced apart by a first protruding structure 341 of the hinge cover 340.

According to an embodiment, the first supporting portion 310 and the second supporting portion 320 may each include a first heat conducting member 410. The first heat conducting member 410 may be disposed at a portion of the first supporting portion 310 contacting the second supporting portion 320, and a portion of the second supporting portion 320 contacting the first supporting portion 310. As the first heat conducting member 410 is deformable, it may prevent damage to the first supporting portion 310 and the second supporting portion 320 when they collide with each other while changing from the second folded state to the unfolded state.

According to the above-described embodiment, the electronic device 101 may reduce damage to the electronic device 101 by heat emitted from the at least one electronic component 301, by including the first supporting portion 310 and the second supporting portion 320 configured to form the heat transfer path p from the at least one electronic component 301 to the second housing 220 in the unfolded state. The first supporting portion 310 and the second supporting portion 320 may reduce damage to the first supporting portion 310 and the second supporting portion 320 and increase thermal conduction efficiency of the heat transfer path p, by each including the first heat conducting member 410 disposed at a position where the first supporting portion 310 and the second supporting portion 320 are contacted with each other.

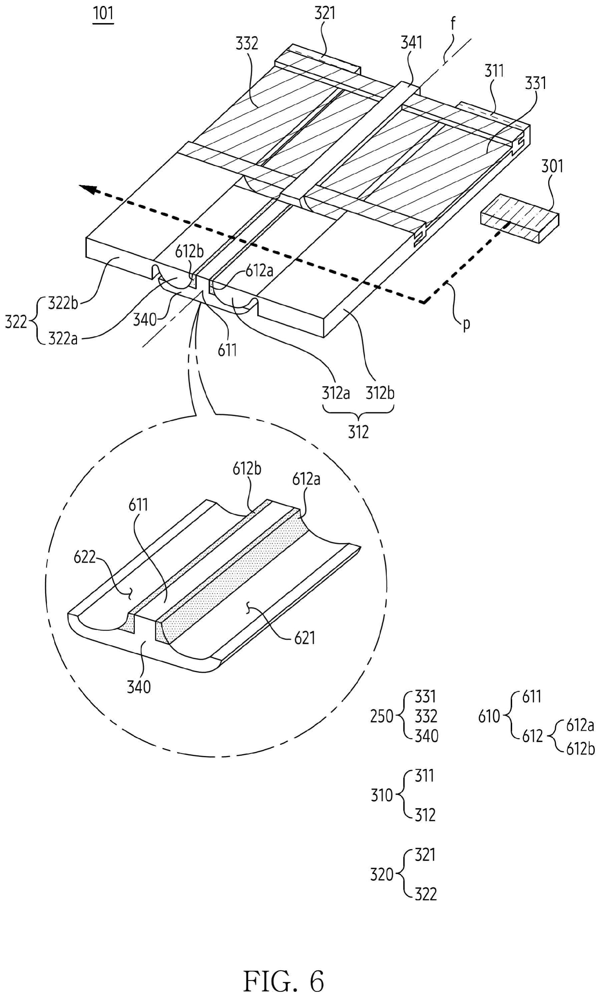

FIG. 6 illustrates a portion of an exemplary electronic device in an unfolded state.

Referring to FIG. 6, the electronic device 101 may include a first housing (e.g., the first housing 210 of FIG. 2A) including a first supporting portion 310 and a second housing (e.g., the second housing 220 of FIG. 2A) including a second supporting portion 320 facing the first supporting portion 310. The electronic device 101 may include at least one electronic component 301 in the first housing 210. The electronic device 101 may include a hinge structure 250 configured to provide a plurality of folded states in which the second housing 220 is folded relative to a folding axis f with respect to the first housing 210 and an unfolded state by rotatably coupling the first supporting portion 310 and the second supporting portion 320. The first supporting portion 310 may be configured to form a heat transfer path p from the at least one electronic component 301 to the second housing 220 by being connected to the second supporting portion 320 in the unfolded state. According to an embodiment, the hinge structure 250 may include a first hinge plate 331 coupled to the first housing 210, a second hinge plate 332 coupled to the second housing 220 and spaced apart from the first hinge plate 331, and a hinge cover 340 rotatably connecting the first hinge plate 331 and the second hinge plate 332.

According to an embodiment, the hinge cover 340 may include a second protruding structure 610 separating the first supporting portion 310 and the second supporting portion 320. The first supporting portion 310 and the second supporting portion 320 may be configured to form the heat transfer path p through the second protruding structure 610 by contacting the second protruding structure 610 in the unfolded state. For example, the second protruding structure 610 may extend from a first protruding structure 341 separating the first hinge plate 331 and the second hinge plate 332. The second protruding structure 610 may extend along the folding axis f. The second protruding structure 610 may provide the folding axis f together with the first protruding structure 341.

For example, the first supporting portion 310 may include a first portion 311 coupled to the first hinge plate 331 and a second portion 312 extending from the first portion 311. The second portion 312 may include a first region 312a contacting the second protruding structure 610 within the unfolded state. The second supporting portion 320 may include a third portion 321 coupled to the second hinge plate 332, and a fourth portion 322 extending from the third portion 321. The fourth portion 322 may include a second region 322a contacting the second protruding structure 610 in the unfolded state. The second protruding structure 610 may separate the first region 312a and the second region 322a from each other in the unfolded state. The protruding structure 610 may require a structure for increasing thermal conduction efficiency of the heat transfer path p formed by the first region 312a and the second region 322a in the unfolded state.

According to an embodiment, the second protruding structure 610 may include a deformable second heat conducting member 612 contacting the first supporting portion 310 and the second supporting portion 320 in the unfolded state. For example, the second protruding structure 610 may include a partition wall 611 and the second heat conducting member 612 attached to the partition wall 611. The second heat conducting member 612 may contact the first supporting portion 310 and the second supporting portion 320 in the unfolded state. For example, the second heat conducting member 612 may be disposed toward the first supporting portion 310 and the second supporting portion 320 in the unfolded state and the plurality of folded states. For example, the hinge cover 340 may include a first seating groove 621 and a second seating groove 622 extending from the partition wall 611. The first region 312a of the first supporting portion 310 may be rotated within the first seating groove 621. The second region 322a of the second supporting portion 320 may be rotated within the second seating groove 622. The second heat conducting member 612 may contact the first region 312a and the second region 322a in the unfolded state by being positioned in at least a portion of an inner surface of the first seating groove 621 and an inner surface of the second seating groove 622. The second protruding structure 610 may increase the thermal conduction efficiency of the heat transfer path p formed by the first supporting portion 310, the second supporting portion 320, and the second protruding structure 610, by including the second heat conducting member 612. According to an embodiment, the second heat conducting member 612 is deformable, it may reduce damage to the first supporting portion 310 and/or the second supporting portion 320 when the first supporting portion 310 and/or the second supporting portion 320 collide with the partition wall 611 while changing from a folded state to the unfolded state.

According to an embodiment, the second heat conducting member 612 may include a third heat conduction part 612a contacting the first region 312a in the unfolded state, and a fourth heat conduction part 612b contacting the second region 322a in the unfolded state. For example, the third heat conduction part 612a and the fourth heat conduction part 612b may be attached to the partition wall 611. The third heat conduction part 612a and the fourth heat conduction part 612b may be separated from each other relative to the partition wall 611. For example, the third heat conduction part 612a may extend from the first seating groove 621 for the first region 312a. The fourth heat conduction part 612b may extend from the second seating groove 622 for the second region 322a. For example, the first region 312a may receive heat from the at least one electronic component 301 in the unfolded state. In the unfolded state, the heat transferred from the at least one electronic component 301 to the first region 312a may be transferred to the second housing 220 through the third heat conduction part 612a contacting the first region 312a, the hinge cover 340 (or the partition wall 611), the fourth heat conduction part 612b, and the second region 322a contacting the fourth heat conduction part 612b. The first region 312a, the third heat conduction part 612a, the partition wall 611, the fourth heat conduction part 612b, and the second region 322a may form the heat transfer path p for the heat.

It is described and illustrated that the second heat conducting member 612 includes the third heat conduction part 612a and the fourth heat conduction part 612b separated from each other relative to the partition wall 611, but it is not limited thereto. Unlike the illustration, the second heat conducting member 612 may cover the partition wall 611. For example, the second heat conducting member 612 may include the third heat conduction part 612a contacting the first region 312a in the unfolded state, the fourth heat conduction part 612b contacting the second region 322a in the unfolded state, and another heat conduction part extending from the third heat conduction part 612a to the fourth heat conduction part 612b and attached on the partition wall 611. The second heat conducting member 612 may increase thermal conduction efficiency of the heat transfer path p from the at least one electronic component 301 to the second housing 220 by covering the partition wall 611.

According to the above-described embodiment, the hinge structure 250 may reduce damage to the electronic device 101 by heat emitted from the at least one electronic component 301, by including the second protruding structure 610 forming the heat transfer path p from the at least one electronic component 301 to the second housing 220 together with the first supporting portion 310 and the second supporting portion 320. The second protruding structure 610 may increase the thermal conduction efficiency of the heat transfer path p by including the second heat conducting member 612 contacting the first supporting portion 310 and the second supporting portion 320 in the unfolded state.

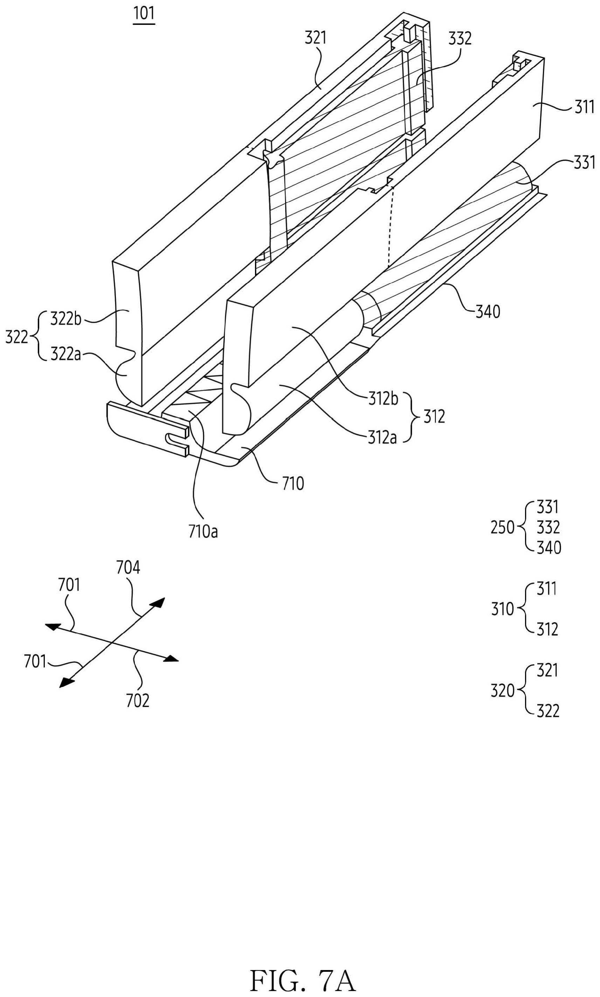

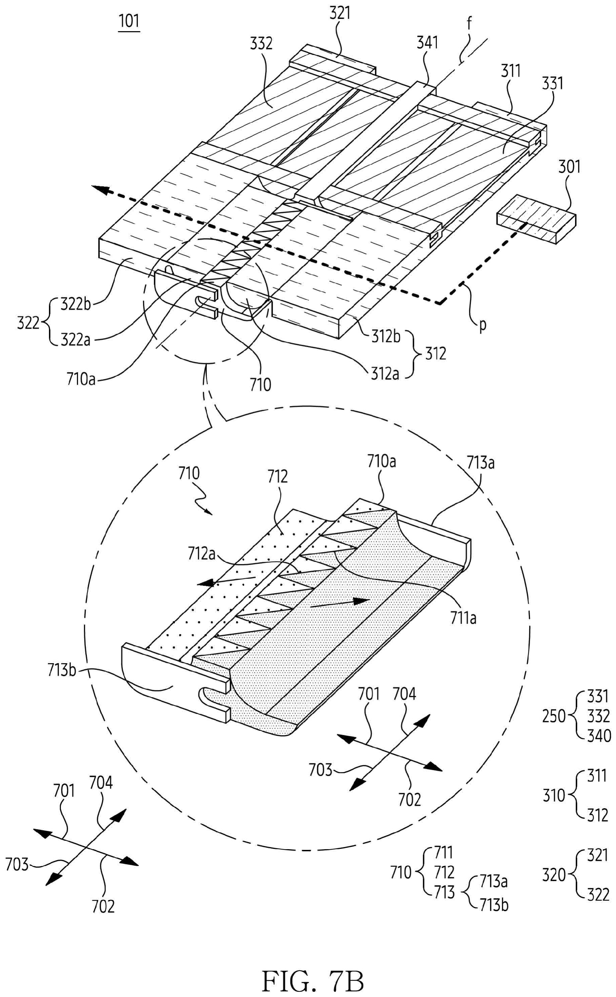

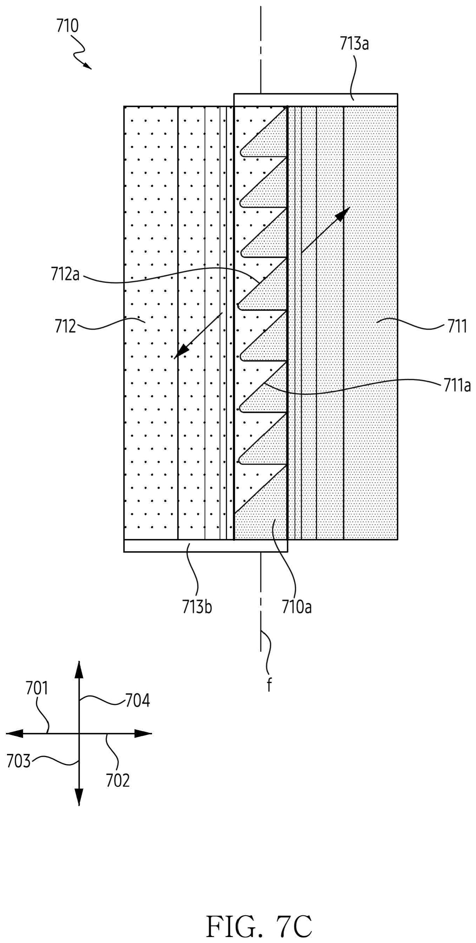

FIG. 7A illustrates a portion of an exemplary electronic device in a first folded state. FIG. 7B illustrates a portion of an exemplary electronic device in an unfolded state. FIG. 7C is a top plan view of a supporting structure of an exemplary electronic device.

Referring to FIGS. 7A and 7B, an electronic device 101 may include a first housing (e.g., the first housing 210 of FIG. 2A) including a first supporting portion 310 and a second housing (e.g., the second housing 220 of FIG. 2A) including a second supporting portion 320 facing the first supporting portion 310. The electronic device 101 may include at least one electronic component 301 in the first housing 210. The electronic device 101 may include a hinge structure 250 configured to provide a plurality of folded states in which the second housing 220 is folded relative to a folding axis f with respect to the first housing 210 and an unfolded state by rotatably coupling the first supporting portion 310 and the second supporting portion 320. The first supporting portion 310 may be configured to form a heat transfer path p from the at least one electronic component 301 to the second housing 220 by being connected to the second supporting portion 320 in the unfolded state. According to an embodiment, the hinge structure 250 may include a first hinge plate 331 coupled to the first housing 210, a second hinge plate 332 coupled to the second housing 220 and spaced apart from the first hinge plate 331, and a hinge cover 340 rotatably connecting the first hinge plate 331 and the second hinge plate 332.

According to an embodiment, the electronic device 101 may include a supporting structure 710 contacting the first supporting portion 310 and the second supporting portion 320 and including a protrusion 710a separating the first supporting portion 310 and the second supporting portion 320 in the unfolded state. The protrusion 710a may be configured to be pressed by the first supporting portion 310 in a first direction 701 perpendicular to the folding axis f, and to be pressed by the second supporting portion 320 in a second direction 702 perpendicular to the folding axis f and opposite to the first direction 701 in the unfolded state.

For example, the supporting structure 710 may be disposed on the hinge cover 340. For example, a thermal conductivity of the supporting structure 710 may be greater than a thermal conductivity of the first supporting portion 310 and a thermal conductivity of the second supporting portion 320. For example, the supporting structure 710 may be deformable. For example, the supporting structure 710 may contact the first supporting portion 310 and the second supporting portion 320 in the unfolded state and the plurality of folded states. For example, the supporting structure 710 may be positioned on the folding axis f. For example, the supporting structure 710 may be configured to form the heat transfer path p from the at least one electronic component 301 to the second housing 220 by contacting the first supporting portion 310 and the second supporting portion 320 in the unfolded state.

For example, the protrusion 710a may be disposed between the first supporting portion 310 and the second supporting portion 320. For example, while changing from the plurality of folded states to the unfolded state, the protrusion 710a may be pressed in the first direction 701 by the first supporting portion 310 moving along the first hinge plate 331. While changing from the plurality of folded states to the unfolded state, the protrusion 710a may be pressed in the second direction 702 opposite to the first direction 701 by the second supporting portion 320 moving along the second hinge plate 332. For example, the protrusion 710a may be pressed in the first direction 701 by a first region 312a of the first supporting portion 310 contacting the supporting structure 710. The protrusion 710a may be pressed in the second direction 702 opposite to the first direction 701 by a second region 322a of the second supporting portion 320 contacting the supporting structure 710. As the protrusion 710a is pressed, a gap may be formed between the supporting structure 710 and the first supporting portion 310, or a gap may be formed between the supporting structure 710 and the second supporting portion 320. As a gap is formed between the supporting portions 310 and 320 and the supporting portion 320, thermal conduction efficiency of the heat transfer path p may be reduced. The supporting structure 710 may require a structure for reducing the gap in order to increase the thermal conduction efficiency of the heat transfer path p.

According to an embodiment, the supporting structure 710 may include a first support member 711, a second support member 712, and an elastic structure 713. The first support member 711 may include a first fastening portion 711a having a zigzag shape. A second fastening portion 712a may include the second fastening portion 712a having a zigzag shape corresponding to a shape of the first fastening portion 711a so as to be fastened to the first fastening portion 711a. The elastic structure 713 may include a first elastic member 713a pressing the first support member 711 in a third direction 703 parallel to the folding axis f, and a second elastic member 713b pressing the second support member 712 in a fourth direction 704 parallel to the folding axis f and opposite to the third direction 703. The protrusion 710a may be configured to press the first supporting portion 310 and the second supporting portion 320 in a direction inclined with respect to the first direction 701 and the third direction 703 and/or in a direction inclined with respect to the second direction 702 and the fourth direction 704 by the elastic structure 713 in the unfolded state.

For example, the first support member 711 may be at least partially disposed between the hinge cover 340 and the first supporting portion 310. For example, the first support member 711 may contact the first region 312a of the first supporting portion 310. For example, a thermal conductivity of the first support member 711 may be higher than a thermal conductivity of the first supporting portion 310. For example, the first support member 711 may have elasticity by being deformable. For example, the first fastening portion 711a may form at least a portion of the protrusion 710a. For example, the first fastening portion 711a may be a portion of the first support member 711 contacting the second support member 712.

For example, the second support member 712 may be at least partially disposed between the hinge cover 340 and the second supporting portion 320. For example, the second support member 712 may contact the second region 322a of the second supporting portion 320. For example, a thermal conductivity of the second support member 712 may be higher than a thermal conductivity of the second supporting portion 320. For example, the second support member 712 may have elasticity by being deformable. For example, the second fastening portion 712a may form the protrusion 710a together with the first fastening portion 711a. For example, the second fastening portion 712a may fasten the second support member 712 to the first support member 711 by being fastened with the first fastening portion 712a.

For example, the elastic structure 713 may press the first support member 711 and the second support member 712 in a direction parallel to the folding axis f in order to maintain fastening between the first support member 711 and the second support member 712. For example, the first elastic member 713a may be disposed on a side surface of the supporting structure 710. The first elastic member 713a may press the protrusion 710a in the third direction 703 parallel to the folding axis f. The second elastic member 713b may be disposed on another side surface opposite to the side surface of the supporting structure 710. The second elastic member 713b may press the protrusion 710a in the fourth direction 704 parallel to the folding axis f and opposite to the third direction 703.

For example, while changing from the plurality of folded states to the unfolded state, the first support member 711 may be pressed by the first supporting portion 310 in the first direction 701. The second support member 712 may be pressed by the second supporting portion 320 in the second direction 702 opposite to the first direction 701. The elastic structure 713 may press the first support member 711 and the second support member 712 in a direction (e.g., the third direction 703 and the fourth direction 704) perpendicular to the first direction 701 and the second direction 702. By the zigzag shape of the first fastening portion 711a and the second fastening portion 712a, the protrusion 710a pressed by the elastic structure 713 may press the supporting portions 310 and 320 in the direction inclined with respect to the first direction 701 and the third direction 703. For example, the first support member 711 and the second support member 712 of the supporting structure 710 may each have elasticity. The supporting structure 710 may generate a displacement toward the first supporting portion 310 by the first support member 711 pressed by the elastic structure 713. The supporting structure 710 may generate a displacement toward the second supporting portion 320 by the second support member 712 pressed by the elastic structure 713. The supporting structure 710 may reduce the formation of the gap between the supporting structure 710 and the supporting portions 310 and 320 by generating a displacement in the direction inclined with respect to the first direction 701 and the third direction 703, respectively, toward the supporting portions 310 and 320. The supporting structure 710 may increase the thermal conduction efficiency of the heat transfer path p formed by the supporting structure 710 and the supporting portions 310 and 320, by reducing the formation of the gap.

According to the above-described embodiment, the electronic device 101 may reduce damage to the electronic device 101 by heat generated from the at least one electronic component 301, by including the supporting structure 710 forming the heat transfer path p from the at least one electronic component 301 to the second housing 220 together with the supporting portions 310 and 320. The supporting structure 710 may increase the thermal conduction efficiency of the heat transfer path p by being configured to press the supporting portions 310 and 320 in the direction inclined with respect to the first direction 701 perpendicular to the folding axis f and the third direction 703 parallel to the folding axis f in the unfolded state.

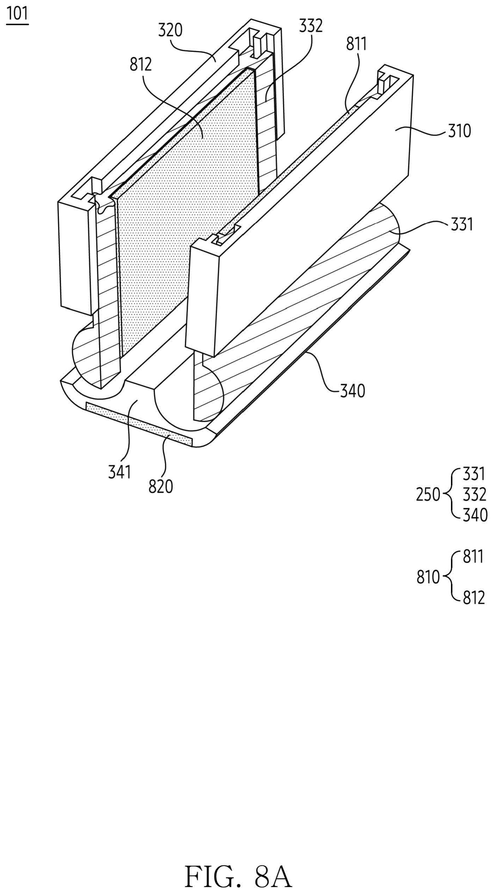

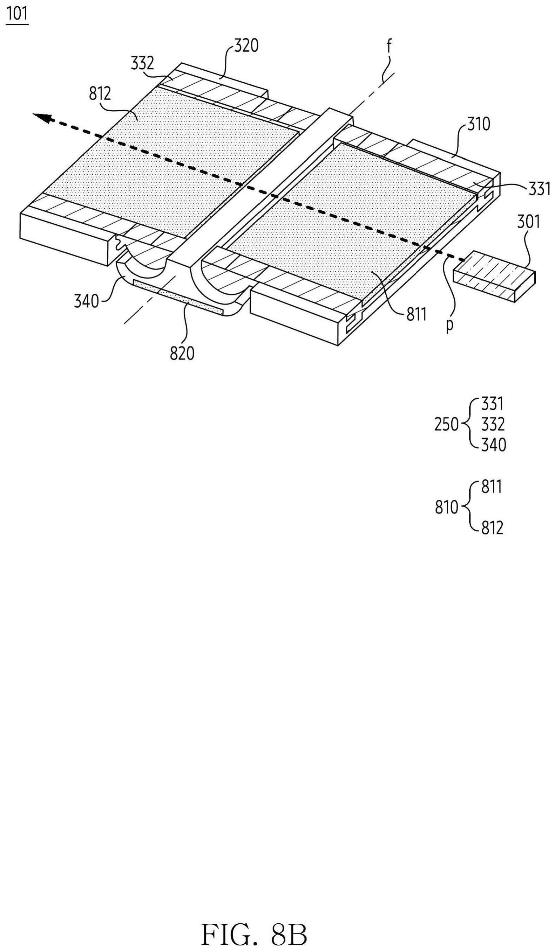

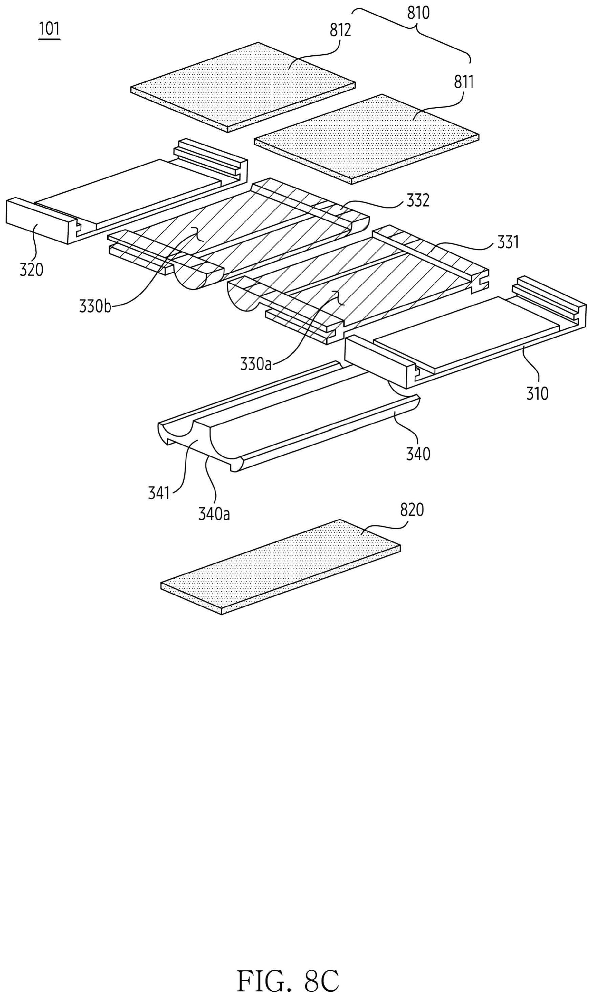

FIG. 8A illustrates a portion of an exemplary electronic device in a first folded state. FIG. 8B illustrates a portion of an exemplary electronic device in an unfolded state. FIG. 8C is a partially exploded perspective view of an exemplary electronic device.

Referring to FIGS. 8A and 8B, an electronic device 101 may include a first housing (e.g., the first housing 210 of FIG. 2A) including a first supporting portion 310 and a second housing (e.g., the second housing 220 of FIG. 2A) including a second supporting portion 320 facing the first supporting portion 310. The electronic device 101 may include at least one electronic component 301 in the first housing 210. The electronic device 101 may include a hinge structure 250 configured to provide a plurality of folded states in which the second housing 220 is folded relative to a folding axis f with respect to the first housing 210 and an unfolded state by rotatably coupling the first supporting portion 310 and the second supporting portion 320. The first supporting portion 310 may be configured to form a heat transfer path p from the at least one electronic component 301 to the second housing 220 by being connected to the second supporting portion 320 in the unfolded state. According to an embodiment, the hinge structure 250 may include a first hinge plate 331 coupled to the first housing 210, a second hinge plate 332 coupled to the second housing 220 and spaced apart from the first hinge plate 331, and a hinge cover 340 rotatably connecting the first hinge plate 331 and the second hinge plate 332.

According to an embodiment, the first hinge plate 331 may be coupled to the first supporting portion 310. The second hinge plate 332 may be coupled to the second supporting portion 320. The hinge cover 340 may include a first protruding structure 341 on the folding axis f separating the first hinge plate 331 and the second hinge plate 332. The electronic device 101 may include a third heat conducting member 810 attached on the first hinge plate 331 and the second hinge plate 332 and contacting the first protruding structure 341. For example, the third heat conducting member 810 may cover at least a portion of the first hinge plate 331 and at least a portion of the second hinge plate 332. For example, a thermal conductivity of the third heat conducting member 810 may be greater than a thermal conductivity of the first hinge plate 331 and a thermal conductivity of the second hinge plate 332. For example, the third heat conducting member 810 may be attached on a surface 330a of the first hinge plate 331 facing a display (e.g., the display 230 of FIG. 2A) and a surface 330b of the second hinge plate 332 facing the display 230. For example, the third heat conducting member 810 may form the heat transfer path p from the at least one electronic component 301 in the first housing 210 to the second housing 220 together with the first hinge plate 331, the second hinge plate 332, and the first protruding structure 341 of the hinge cover 340. For example, at least a portion of heat emitted from the at least one electronic component 301 may be transferred to the third heat conducting member 810 through the first supporting portion 310 and the first hinge plate 331 coupled with the first supporting portion 310. The heat transferred to the third heat conducting member 810 may be transferred into the inside of the second housing 220 through the hinge cover 340 and the second hinge plate 332.

According to an embodiment, the third heat conducting member 810 may include a fifth heat conduction part 811 attached on the first hinge plate 331 and a sixth heat conduction part 812 attached on the second hinge plate 332. The fifth heat conduction part 811 and the sixth heat conduction part 812 may contact the first protruding structure 341 of the hinge cover 340 in the unfolded state. For example, the fifth heat conduction part 811 and the sixth heat conduction part 812 may be separated from each other relative to the first protruding structure 341. For example, the fifth heat conduction part 811 may receive heat from the at least one electronic component 301. The heat transferred from the at least one electronic component 301 to the fifth heat conduction part 811 may be transferred to the second housing 220 through the hinge cover 340 (or the first protruding structure 341) contacting the fifth heat conduction part 811 and the sixth heat conduction part 812 contacting the hinge cover 340, in the unfolded state. The fifth heat conduction part 811, the hinge cover 340, and the sixth heat conduction part 812 may form the heat transfer path p for the heat.

According to an embodiment, the electronic device 101 may include a fourth heat conducting member 820 spaced apart from the first hinge plate 331 and the second hinge plate 332 and attached to the hinge cover 340 along the folding axis f. For example, the hinge cover 340 may include a groove 340a for accommodating the fourth heat conducting member 820. The groove 340a may be formed in a direction opposite to a direction toward the display 230. The fourth heat conducting member 820 may be attached in the groove 340a. For example, a thermal conductivity of the fourth heat conducting member 820 may be greater than a thermal conductivity of the hinge cover 340. The electronic device 101 may increase thermal conduction efficiency of the heat transfer path p formed by the first hinge plate 331, the second hinge plate 332, and the hinge cover 340 by including the fourth heat conducting member 820.

According to the above-described embodiment, the electronic device 101 may increase the thermal conduction efficiency of the heat transfer path p, from the at least one electronic component 301 to the second housing 220, formed by the hinge structure 250, by including the third heat conducting member 810 and the fourth heat conducting member 820 attached to the hinge structure 250.

According to the above-described embodiment, an electronic device (e.g., the electronic device 101 of FIG. 1) may comprise a display (e.g., the display 230 of FIG. 2A), a first housing (e.g., the first housing 210 of FIG. 2A) including a first supporting portion (e.g., the first supporting portion 310 of FIG. 3) for supporting the display, and a second housing (e.g., the second housing 220 of FIG. 2A) including a second supporting portion (e.g., the second supporting portion 320 of FIG. 3) for supporting the display. The electronic device may comprise at least one electronic component (e.g., the at least one electronic component 301 of FIG. 3) disposed in the first housing. The electronic device may comprise a hinge structure (e.g., the hinge structure 250 of FIG. 2B) configured to rotatably couple the first housing and second housing. The first supporting portion and the second supporting portion may be configured to form a heat transfer path (e.g., the heat transfer path p of FIG. 4A) from the at least one electronic component to the second housing by being connected to each other in an unfolded state of the electronic device. According to the above-mentioned embodiment, the electronic device may reduce damage to the electronic device by the at least one electronic component by including the first supporting portion forming the heat transfer path together with the second supporting portion in the unfolded state. The above-mentioned embodiment may have various effects including the above-mentioned effect.

According to an embodiment, the hinge structure may include a first hinge plate (e.g., the first hinge plate 331 of FIG. 3) coupled with the first housing, and a second hinge plate (e.g., the second hinge plate 332 of FIG. 3) coupled with the second housing and spaced apart from the first hinge plate. The first supporting portion may be slidably coupled to the first hinge plate at a first portion (e.g., the first portion 311 of FIG. 4B) of the first supporting portion, and may include a second portion (e.g., the second portion 312 of FIG. 4B) extending from the first portion along the folding axis. The second supporting portion may be slidably coupled to the second hinge plate at a third portion (e.g., the third portion 321 of FIG. 4B) of the second supporting portion, and may include a fourth portion (e.g., the fourth portion 322 of FIG. 4B) extending from the third portion along the folding axis. The heat transfer path may be formed by contacting the second portion and the fourth portion in the unfolded state. According to the above-mentioned embodiment, the electronic device may reduce damage to the electronic device by the at least one electronic component by including the fourth portion contacting the second portion in the unfolded state. The above-mentioned embodiment may have various effects including the above-mentioned effect.

According to an embodiment, the hinge structure may further include a hinge cover (e.g., the hinge cover 340 of FIG. 4A). The second portion may include a first region (e.g., the first region 312a of FIG. 4B) disposed between the hinge cover and the display in the unfolded state. The fourth portion may include a second region (e.g., the second region 322a of FIG. 4B) disposed between the hinge cover and the display in the unfolded state and contacting the first region via at least one heat conducting member (e.g., the first heat conducting member 410 of FIG. 4A and/or the second heat conducting member 612 of FIG. 6) which is deformable. For example, the first region and the second region may each include a deformable first heat conducting member (e.g., the first heat conducting member 410 of FIG. 4A). According to the above-mentioned embodiment, the electronic device may increase thermal conduction efficiency of the heat transfer path and reduce damage to the first supporting portion and the second supporting portion in the unfolded state by including the first heat conducting member. The above-mentioned embodiment may have various effects including the above-mentioned effect.

According to an embodiment, the second portion may contact along at least a portion of the hinge cover in the unfolded state. The second portion may be disconnected from the fourth portion by being spaced apart from the fourth portion in a plurality of folded states. According to the above-mentioned embodiment, the electronic device may reduce damage to the electronic device by the at least one electronic component by including the fourth portion contacting the second portion in the unfolded state. The above-mentioned embodiment may have various effects including the above-mentioned effect.

According to an embodiment, the at least one heat conducting member may be disposed at an end of at least one of the first region or the second region.

According to an embodiment, the at least one heat conducting member may be disposed at a portion of the hinge cover.

According to an embodiment, the hinge structure may include a hinge cover including a protruding structure (e.g., the second protruding structure 610 of FIG. 6) separating the first supporting portion and the second supporting portion. The first supporting portion and the second supporting portion may be configured to form the heat transfer path through the protruding structure by contacting the protruding structure in the unfolded state. According to the above-mentioned embodiment, the first supporting portion and the second supporting portion may reduce damage to the electronic device by the at least one electronic component by contacting the protruding structure in the unfolded state. The above-mentioned embodiment may have various effects including the above-mentioned effect.

According to an embodiment, the protruding structure may further include a deformable second heat conducting member (e.g., the second heat conducting member 612 of FIG. 6) contacting the first supporting portion and the second supporting portion in the unfolded state. According to the above-mentioned embodiment, the electronic device may increase the thermal conduction efficiency of the heat transfer path by including the second heat conducting member. The above-mentioned embodiment may have various effects including the above-mentioned effect.

According to an embodiment, the electronic device may further comprise a supporting structure (e.g., the supporting structure 710 of FIG. 7A) contacting the first supporting portion and the second supporting portion, and including a protrusion (e.g., the protrusion 710a of FIG. 7A) separating the first supporting portion and the second supporting portion in the unfolded state. The protrusion may be configured to be pressed by the first supporting portion in a first direction (e.g., the first direction 701 of FIG. 7B) perpendicular to the folding axis and to be pressed by the second supporting portion in a second direction (e.g., the second direction 702 of FIG. 7B) perpendicular to the folding axis and opposite to the first direction in the unfolded state. According to the above-mentioned embodiment, the electronic device may increase the thermal conduction efficiency of the heat transfer path by including the supporting structure. The above-mentioned embodiment may have various effects including the above-mentioned effect.

According to an embodiment, the supporting structure may include a first support member (e.g., the first support member 711 of FIG. 7B) including a first fastening portion (e.g., the first fastening portion 711a of FIG. 7B) having a zigzag shape. The supporting structure may include a second support member (e.g., the second support member 712 of FIG. 7B) including a second fastening portion (e.g., the second fastening portion 712a of FIG. 7B) having a zigzag shape corresponding to a shape of the first fastening portion for fastening to the first fastening portion. The supporting structure may include an elastic structure (e.g., the elastic structure 713 of FIG. 7B) including a first elastic member (e.g., the first elastic member 713a of FIG. 7B) pressing the first support member in a third direction (e.g., the third direction 703 of FIG. 7B) parallel to the folding axis and a second elastic member (e.g., the second elastic member 713b of FIG. 7B) pressing the second support member in a fourth direction (e.g., the fourth direction 704 of FIG. 7B) parallel to the folding axis and opposite to the third direction. The protrusion may be configured to press the first supporting portion and the second supporting portion in a direction inclined with respect to the first direction and the third direction by the elastic structure in the unfolded state. According to the above-mentioned embodiment, the electronic device may increase the thermal conduction efficiency of the heat transfer path by including the supporting structure. The above-mentioned embodiment may have various effects including the above-mentioned effect.

According to an embodiment, the hinge structure may include a first hinge plate coupled with the first supporting portion, and a second hinge plate coupled with the second supporting portion. The hinge structure may include a hinge cover rotatably connecting the first hinge plate and the second hinge plate and including a protruding structure (e.g., the first protruding structure 341 of FIG. 4B) on the folding axis separating the first hinge plate and the second hinge plate. The electronic device may further comprise a third heat conducting member (e.g., the third heat conducting member 810 of FIG. 8A) attached on the first hinge plate and the second hinge plate and contacting the protruding structure. According to the above-mentioned embodiment, the electronic device may increase the thermal conduction efficiency of the heat transfer path by including the third heat conducting member. The above-mentioned embodiment may have various effects including the above-mentioned effect.

According to an embodiment, the electronic device may further comprise a fourth heat conducting member (e.g., the fourth heat conducting member 820 of FIG. 8A) spaced apart from the first hinge plate and the second hinge plate, and attached to the hinge cover along the folding axis. According to the above-mentioned embodiment, the electronic device may increase the thermal conduction efficiency of the heat transfer path by including the fourth heat conducting member. The above-mentioned embodiment may have various effects including the above-mentioned effect.

According to an embodiment, the display may include a first display region (e.g., the first display region 231 of FIG. 2A) coupled on the first housing, a second display region (e.g., the second display region 232 of FIG. 2A) coupled on the second housing, and a third display region (e.g., the third display region 233 of FIG. 2A), which is deformable, extending from the first display region to the second display region. According to the above-mentioned embodiment, the electronic device may provide various user experiences to a user by including the display including the deformable third region. The above-mentioned embodiment may have various effects including the above-mentioned effect.

According to an embodiment, the electronic device may further comprise a vapor chamber (e.g., the vapor chamber 420 of FIG. 4A) in the first housing contacting the at least one electronic component and the first supporting portion, and forming the heat transfer path by extending from the at least one electronic component to the first supporting portion. According to the above-mentioned embodiment, the electronic device may form the heat transfer path in the first housing by including the vapor chamber. The above-mentioned embodiment may have various effects including the above-mentioned effect.

According to an embodiment, the second housing may further include a heat dissipation member (e.g., the heat dissipation member 430 of FIG. 4A) attached to the second supporting portion and configured to contact the vapor chamber in the unfolded state. According to the above-mentioned embodiment, the electronic device may form the heat transfer path in the second housing by including the heat dissipation member. The above-mentioned embodiment may have various effects including the above-mentioned effect.

According to an embodiment, the first supporting portion and the second supporting portion may each include at least one of aluminum, thermal grease, and SMT gasket. According to the above-mentioned embodiment, the first supporting portion and the second supporting portion may increase the thermal conduction efficiency of the heat transfer path by including members having a relatively high thermal conductivity. The above-mentioned embodiment may have various effects including the above-mentioned effect.

According to an embodiment, a thermal conductivity (e.g., c1 of FIG. 4B) of the first supporting portion and a thermal conductivity (e.g., c2 of FIG. 4B) of the second supporting portion may be greater than a thermal conductivity (e.g., c3 of FIG. 4B) of the hinge structure. According to the above-mentioned embodiment, as the thermal conductivity of the first supporting portion and the thermal conductivity of the second supporting portion is greater than the thermal conductivity of the hinge structure, thereby increasing the thermal conduction efficiency of the heat transfer path. The above-mentioned embodiment may have various effects including the above-mentioned effect.

According to an embodiment, an electronic device may comprise a first housing including a first supporting portion, and a second housing including a second supporting portion facing the first supporting portion. The electronic device may comprise a flexible display including a first display region coupled on the first housing, a second display region coupled on the second housing, and a third display region, which is deformable, extending from the first display region to the second display region. The electronic device may comprise at least one electronic component in the first housing. The electronic device may comprise a vapor chamber in the first housing contacting the at least one electronic component and the first supporting portion, and extending from the at least one electronic component to the first supporting portion. The electronic device may comprise a hinge structure configured to provide a plurality of folded states in which the second housing is folded relative to a folding axis with respect to the first housing and an unfolded state by rotatably coupling the first supporting portion and the second supporting portion. The first supporting portion may be configured to form a heat transfer path from the at least one electronic component through the vapor chamber to the second housing by being connected with the second supporting portion in the unfolded state. According to the above-mentioned embodiment, the electronic device may reduce damage to the electronic device by the at least one electronic component by including the first supporting portion forming the heat transfer path together with the second supporting portion in the unfolded state. The electronic device may provide various user experiences to a user by including the display including the deformable third region. The above-mentioned embodiment may have various effects including the above-mentioned effect.

According to an embodiment, the hinge structure may include a first hinge plate coupled with the first housing, and a second hinge plate coupled with the second housing and spaced apart from the first hinge plate. The first supporting portion may be slidably coupled to the first hinge plate, and may include a first portion supporting the first hinge plate and a second portion extending from the first portion along the folding axis. The second supporting portion may be slidably coupled to the second hinge plate, and may include a third portion supporting the second hinge plate and a fourth portion extending from the third portion along the folding axis. The second portion may be configured to form the heat transfer path by contacting the fourth portion in the unfolded state. According to the above-mentioned embodiment, the electronic device may reduce damage to the electronic device by the at least one electronic component by including the fourth portion contacting the second portion in the unfolded state. The above-mentioned embodiment may have various effects including the above-mentioned effect.

According to an embodiment, the hinge structure may include a hinge cover including a protruding structure separating the first supporting portion and the second supporting portion. The first supporting portion and the second supporting portion may be configured to form the heat transfer path through the protruding structure by contacting the protruding structure in the unfolded state. According to the above-mentioned embodiment, the first supporting portion and the second supporting portion may reduce damage to the electronic device by the at least one electronic component by contacting the protruding structure in the unfolded state. The above-mentioned embodiment may have various effects including the above-mentioned effect.

According to an embodiment, the electronic device may further comprise a supporting structure contacting the first supporting portion and the second supporting portion, and including a protrusion separating the first supporting portion and the second supporting portion in the unfolded state. The protrusion may be configured to be pressed by the first supporting portion in a first direction perpendicular to the folding axis and to be pressed by the second supporting portion in a second direction perpendicular to the folding axis and opposite to the first direction in the unfolded state. According to the above-mentioned embodiment, the electronic device may increase thermal conduction efficiency of the heat transfer path by including the supporting structure. The above-mentioned embodiment may have various effects including the above-mentioned effect.

According to an embodiment, the supporting structure may include a first support member including a first fastening portion having a zigzag shape. The supporting structure may include a second support member including a second fastening portion having a zigzag shape corresponding to a shape of the first fastening portion for fastening to the first fastening portion. The supporting structure may include an elastic structure including a first elastic member pressing the first support member in a third direction parallel to the folding axis and a second elastic member pressing the second support member in a fourth direction parallel to the folding axis and opposite to the third direction. The protrusion may be configured to press the first supporting portion and the second supporting portion in a direction inclined with respect to the first direction and the third direction by the elastic structure in the unfolded state. According to the above-mentioned embodiment, the electronic device may increase the thermal conduction efficiency of the heat transfer path by including the supporting structure. The above-mentioned embodiment may have various effects including the above-mentioned effect.

The electronic device according to various embodiments may be one of various types of electronic devices. The electronic devices may include, for example, a portable communication device (e.g., a smartphone), a computer device, a portable multimedia device, a portable medical device, a camera, a wearable device, or a home appliance. According to an embodiment of the disclosure, the electronic devices are not limited to those described above.

It should be appreciated that various embodiments of the present disclosure and the terms used therein are not intended to limit the technological features set forth herein to particular embodiments and include various changes, equivalents, or replacements for a corresponding embodiment. With regard to the description of the drawings, similar reference numerals may be used to refer to similar or related elements. It is to be understood that a singular form of a noun corresponding to an item may include one or more of the things unless the relevant context clearly indicates otherwise. As used herein, each of such phrases as "A or B," "at least one of A and B," "at least one of A or B," "A, B, or C," "at least one of A, B, and C," and "at least one of A, B, or C," may include any one of or all possible combinations of the items enumerated together in a corresponding one of the phrases. As used herein, such terms as "1st" and "2nd," or "first" and "second" may be used to simply distinguish a corresponding component from another, and does not limit the components in other aspect (e.g., importance or order). It is to be understood that if an element (e.g., a first element) is referred to, with or without the term "operatively" or "communicatively", as "coupled with," or "connected with" another element (e.g., a second element), it means that the element may be coupled with the other element directly (e.g., wiredly), wirelessly, or via a third element.

As used in connection with various embodiments of the disclosure, the term "module" may include a unit implemented in hardware, software, or firmware, and may interchangeably be used with other terms, for example, "logic," "logic block," "part," or "circuitry". A module may be a single integral component, or a minimum unit or part thereof, adapted to perform one or more functions. For example, according to an embodiment, the module may be implemented in a form of an application-specific integrated circuit (ASIC).

Various embodiments as set forth herein may be implemented as software (e.g., the program 140) including one or more instructions that are stored in a storage medium (e.g., internal memory 136 or external memory 138) that is readable by a machine (e.g., the electronic device 101). For example, a processor (e.g., the processor 120) of the machine (e.g., the electronic device 101) may invoke at least one of the one or more instructions stored in the storage medium, and execute it, with or without using one or more other components under the control of the processor. This allows the machine to be operated to perform at least one function according to the at least one instruction invoked. The one or more instructions may include a code generated by a compiler or a code executable by an interpreter. The machine-readable storage medium may be provided in the form of a non-transitory storage medium. Wherein, the term "non-transitory" simply means that the storage medium is a tangible device, and does not include a signal (e.g., an electromagnetic wave), but this term does not differentiate between a case in which data is semi-permanently stored in the storage medium and a case in which the data is temporarily stored in the storage medium.

According to an embodiment, a method according to various embodiments of the disclosure may be included and provided in a computer program product. The computer program product may be traded as a product between a seller and a buyer. The computer program product may be distributed in the form of a machine-readable storage medium (e.g., compact disc read only memory (CD-ROM)), or be distributed (e.g., downloaded or uploaded) online via an application store (e.g., PlayStore^{™}), or between two user devices (e.g., smart phones) directly. If distributed online, at least part of the computer program product may be temporarily generated or at least temporarily stored in the machine-readable storage medium, such as memory of the manufacturer's server, a server of the application store, or a relay server.

According to various embodiments, each component (e.g., a module or a program) of the above-described components may include a single entity or multiple entities, and some of the multiple entities may be separately disposed in different components. According to various embodiments, one or more of the above-described components may be omitted, or one or more other components may be added. Alternatively or additionally, a plurality of components (e.g., modules or programs) may be integrated into a single component. In such a case, according to various embodiments, the integrated component may still perform one or more functions of each of the plurality of components in the same or similar manner as they are performed by a corresponding one of the plurality of components before the integration. According to various embodiments, operations performed by the module, the program, or another component may be carried out sequentially, in parallel, repeatedly, or heuristically, or one or more of the operations may be executed in a different order or omitted, or one or more other operations may be added.

## Claims

1. An electronic device (101) comprising:
a display (230);
a first housing (210) including a first supporting portion (310) for supporting the display (230);
a second housing (220) including a second supporting portion (320) for supporting the display (230);
at least one electronic component (301) disposed in the first housing (210); and
a hinge structure (250) configured to rotatably couple the first housing (210) and second housing (220),
wherein, the first supporting portion (310) and the second supporting portion (320) are configured to provide a heat transfer path (p) from the at least one electronic component (301) to the second housing (220) by being connected to each other in an unfolded state of the electronic device (101).

2. The electronic device (101) of claim 1,
wherein, the hinge structure (250) includes:
a first hinge plate (252; 331) coupled with the first housing (210); and
a second hinge plate (253; 332) coupled with the second housing (220) and spaced apart from the first hinge plate (252; 331);
wherein, the first supporting portion (310) is slidably coupled to the first hinge plate (252; 331) at a first portion (311) of the first supporting portion (310), and includes a second portion (312) extending from the first portion (311) along a folding axis (f),
wherein, the second supporting portion (320) is slidably coupled to the second hinge plate (253; 332) at a third portion (321) of the second supporting portion (320), and includes a fourth portion (322) extending from the third portion (321) along the folding axis (f), and
wherein, the heat transfer path (p) is formed by contacting the second portion (312) and the fourth portion (322) in the unfolded state.

3. The electronic device (101) of claim 1 or claim 2,
wherein, the hinge structure (250) further includes a hinge cover (251; 340),
wherein, the second portion (312) includes a first region (312a) disposed between the hinge cover (251; 340) and the display (230) in the unfolded state, and
wherein, the fourth portion (322) includes a second region (322a) disposed between the hinge cover (251; 340) and the display (230) in the unfolded state and contacting the first region (312a) via at least one heat conducting member (410) which is deformable.

4. The electronic device (101) of any one of claims 1 to 3,
wherein, the second portion (312) contacts the fourth portion (322) along at least a portion of the hinge cover (251; 340) in the unfolded state, and is disconnected from the fourth portion (322) in a plurality of folded states.

5. The electronic device (101) of any one of claims 1 to 4,
wherein, the at least one heat conducting member (410) is disposed at an end of at least one of the first region (312a) or the second region (322a).

6. The electronic device (101) of any one of claims 1 to 5,
wherein, the at least one heat conducting member (410) is disposed at a portion of the hinge cover (251; 340).

7. The electronic device (101) of any one of claims 1 to 6, further comprising:
a supporting structure (710) contacting the first supporting portion (310) and the second supporting portion (320), and including a protrusion (710a) separating the first supporting portion (310) and the second supporting portion (320) in the unfolded state,
wherein, the protrusion (710a) is configured to be pressed by the first supporting portion (310) in a first direction (701) perpendicular to a folding axis (f) and to be pressed by the second supporting portion (320) in a second direction (702) perpendicular to the folding axis (f) and opposite to the first direction (701) in the unfolded state.

8. The electronic device (101) of any one of claims 1 to 7,
wherein, the supporting structure (710) includes:
a first support member (711) including a first fastening portion (711a) having a zigzag shape;
a second support member (712) including a second fastening portion (712a) having a zigzag shape corresponding to a shape of the first fastening portion (711a) for fastening to the first fastening portion (711a); and
an elastic structure (713) including a first elastic member (713a) pressing the first support member (711) in a third direction (703) parallel to the folding axis (f) and a second elastic member (713b) pressing the second support member (712) in a fourth direction (704) parallel to a folding axis (f) and opposite to the third direction (703); and,
wherein, the protrusion (710a) is configured to press the first supporting portion (310) and the second supporting portion (320) in a direction inclined with respect to the first direction (701) and the third direction (703) by the elastic structure (713) in the unfolded state.

9. The electronic device (101) of any one of claims 1 to 8,
wherein, the hinge structure (250) includes:
a first hinge plate (252; 331) coupled with the first supporting portion (310);
a second hinge plate (253; 332) coupled with the second supporting portion (320); and
a hinge cover (251; 340) rotatably connecting the first hinge plate (252; 331) and the second hinge plate (253; 332) and including a protruding structure (341) on a folding axis (f) separating the first hinge plate (252; 331) and the second hinge plate (253; 332), and
wherein, the electronic device (101) further comprises a third heat conducting member (810) attached on the first hinge plate (252; 331) and the second hinge plate (253; 332) and contacting the protruding structure (341).

10. The electronic device (101) of any one of claims 1 to 9, further comprising:
a fourth heat conducting member (410) spaced apart from the first hinge plate (252; 331) and the second hinge plate (253; 332), and attached to the hinge cover (251; 340) along the folding axis (f).

11. The electronic device (101) of any one of claims 1 to 10,
wherein, the display (230) includes:
a first display region (231) coupled on the first housing (210);
a second display region (232) coupled on the second housing (220); and
a third display region (233), which is deformable, extending from the first display region (231) to the second display region (232).

12. The electronic device (101) of any one of claims 1 to 11, further comprising:
a vapor chamber (420) in the first housing (210) contacting the at least one electronic component (301) and the first supporting portion (310), and forming the heat transfer path (p) by extending from the at least one electronic component (301) to the first supporting portion (310).

13. The electronic device (101) of any one of claims 1 to 12,
wherein, the second housing (220) further includes a heat dissipation member (430) attached to the second supporting portion (320) and configured to contact the vapor chamber (420) in the unfolded state.

14. The electronic device (101) of any one of claims 1 to 13,
wherein, the first supporting portion (310) and the second supporting portion (320) each include at least one of aluminum, thermal grease, and SMT gasket.

15. The electronic device (101) of any one of claims 1 to 14,
wherein, a thermal conductivity (c1) of the first supporting portion (310) and a thermal conductivity (c2) of the second supporting portion (320) are greater than a thermal conductivity (c3) of the hinge structure (250).
